# EUROPEAN PATENT APPLICATION

(11) **EP 4 557 910 A1**
(43) Date of publication of application: **21.05.2025**
(21) Application number: 24193002.3
(22) Date of filing: 06.08.2024
(51) Int. Cl.: H10D 64/62, H10D 64/23, H10D 62/10, H10D 62/83, H10D 62/13, H10D 30/67, H10D 30/01, H10D 30/43, H10D 64/01

(54) **INTEGRATED CIRCUIT DEVICE**

(30) Priority: 20.11.2023 KR 20230161438
(71) Applicant: Samsung Electronics Co., Ltd, Suwon-si, Gyeonggi-do 16677 (KR)
(72) Inventor: LIM, Sungkeun, 16677 Suwon-si (KR); KIM, Dongwoo, 16677 Suwon-si (KR); KIM, Hyojin, 16677 Suwon-si (KR); PARK, Pankwi, 16677 Suwon-si (KR); CHO, Youngdae, 16677 Suwon-si (KR)
(74) Representative: Marks & Clerk LLP

(57) **Abstract**

An integrated circuit device includes a substrate provided with a fin-type active region which is disposed at a first surface of the substrate, a plurality of nanosheets disposed on a top surface of the fin-type active region and separated from the top surface of the fin-type active region, a gate line disposed on the fin-type active region, the gate line surrounding each of the plurality of nanosheets, a source/drain region disposed on the fin-type active region, a sidewall of the source/drain region being adjacent to the gate line and in contact with the plurality of nanosheets, a backside contact extending from a second surface of the substrate toward a lower portion of the source/drain region, and a high-concentration doped layer disposed in the lower portion of the source/drain region. The high-concentration doped layer has a dopant concentration greater than a dopant concentration of the source/drain region.

## Description

### TECHNICAL FIELD

The present invention relates to an integrated circuit device. More particularly, the present disclosure discusses an integrated circuit device including a backside contact.

### BACKGROUND

With the increased demand for compact and multi-functionalized high-performance electronic products, there is a need for higher capacity and higher integration of integrated circuit devices. Accordingly, it is desirable to efficiently design interconnection structures to achieve higher integration while securing the functions and operating speed required by integrated circuit devices.

### SUMMARY

According to an aspect of the present disclosure, an integrated circuit device includes a substrate provided with a fin-type active region, wherein the fin-type active region is disposed at a first surface of the substrate and extends in a first horizontal direction that is parallel to the first surface of the substrate, a plurality of nanosheets disposed on a top surface of the fin-type active region and separated from the top surface of the fin-type active region, a gate line disposed on the fin-type active region, the gate line surrounding each of the plurality of nanosheets and extending in a second horizontal direction that crosses the first horizontal direction, wherein the second horizontal direction is parallel to the first surface of the substrate, a source/drain region disposed on the fin-type active region, a sidewall of the source/drain region being adjacent to the gate line and in contact with the plurality of nanosheets, a backside contact extending from a second surface of the substrate toward a lower portion of the source/drain region, wherein the second surface of the substrate is opposite to the first surface thereof, and a high-concentration doped layer disposed in the lower portion of the source/drain region. The high-concentration doped layer has a dopant concentration greater than a dopant concentration of the source/drain region.

According to an aspect of the present disclosure, an integrated circuit device includes a fin-type active region disposed on a substrate and extending in a first horizontal direction, wherein the first horizontal direction is parallel to an upper surface of the substrate, a channel region disposed on the fin-type active region, a gate line disposed on the fin-type active region, the gate line surrounding the channel region and extending in a second horizontal direction that crosses the first horizontal direction, wherein the second horizontal direction is parallel to the upper surface of the substrate, a first source/drain region disposed on the fin-type active region, a sidewall of the source/drain region being adjacent to the gate line and in contact with the channel region, a first backside contact extending from a lower surface of the substrate toward a lower portion of the first source/drain region, wherein the lower surface of the substrate is opposite to the upper surface thereof, and a first high-concentration doped layer disposed in the lower portion of the first source/drain region. The first high-concentration doped layer and the first source/drain region include a first dopant, and a concentration of the first dopant in the first high-concentration doped layer is greater than a concentration of the first dopant in the first source/drain region.

According to an aspect of the present disclosure, an integrated circuit device includes a fin-type active region disposed on a substrate and extending in a first horizontal direction, wherein the first horizontal direction is parallel to an upper surface of the substrate, a plurality of nanosheets disposed on a top surface of the fin-type active region, separated from the top surface of the fin-type active region, and having different distances from the top surface of the fin-type active region in a vertical direction that is perpendicular to the upper surface of the substrate, a gate line disposed on the fin-type active region, the gate line surrounding each of the plurality of nanosheets and extending lengthwise in a second horizontal direction that crosses the first horizontal direction, wherein the second horizontal direction is parallel to the upper surface of the substrate, a source/drain region adjacent to the plurality of nanosheets in the first horizontal direction, a backside contact extending from a lower surface of the substrate toward a lower portion of the source/drain region, wherein the lower surface of the substrate is opposite to the upper surface thereof, a high-concentration doped layer disposed in the lower portion of the source/drain region, and a metal silicide film between the high-concentration doped layer and an upper portion of the backside contact. The source/drain region includes a first semiconductor layer contacting the fin-type active region, and a second semiconductor layer on the first semiconductor layer. The metal silicide film is in contact with the high-concentration doped layer. The high-concentration doped layer, the first semiconductor layer, and the second semiconductor layer include a first dopant. A first concentration of the first dopant in the first semiconductor layer is less than a second concentration of the first dopant in the second semiconductor layer. A third concentration of the first dopant in the high-concentration doped layer is greater than the second concentration of the first dopant in the second semiconductor layer.

Preferred embodiments are defined by the dependent claims.

### BRIEF DESCRIPTION OF THE DRAWINGS

Embodiments will be more clearly understood from the following detailed description taken in conjunction with the accompanying drawings in which:
FIG. 1 is a diagram illustrating a layout of a cell block of an integrated circuit device, according to some embodiments;
FIG. 2 is a layout diagram illustrating an integrated circuit device according to some embodiments;
FIGS. 3A to 3C are cross-sectional views illustrating an integrated circuit device according to some embodiments;
FIG. 4 is an enlarged cross-sectional view illustrating an integrated circuit device according to some embodiments;
FIGS. 5A to 5C are enlarged cross-sectional views illustrating integrated circuit devices according to some embodiments;
FIGS. 6 and 7 are enlarged cross-sectional views illustrating integrated circuit devices according to some embodiments;
FIG. 8 is a cross-sectional view illustrating an integrated circuit device according to some embodiments;
FIG. 9 is a cross-sectional view illustrating an integrated circuit device according to some embodiments;
FIG. 10 is an enlarged cross-sectional view illustrating an integrated circuit device according to some embodiments;
FIGS. 11 to 13 are cross-sectional views illustrating integrated circuit devices according to some embodiments; and
FIGS. 14 to 28 are cross-sectional views of an integrated circuit device illustrating process steps of a method of manufacturing the integrated circuit device according to some embodiments.

### DETAILED DESCRIPTION OF THE EMBODIMENTS

Hereinafter, embodiments are described with reference to the accompanying drawings. In the drawing, like reference characters denote like elements, and redundant descriptions thereof will be omitted.

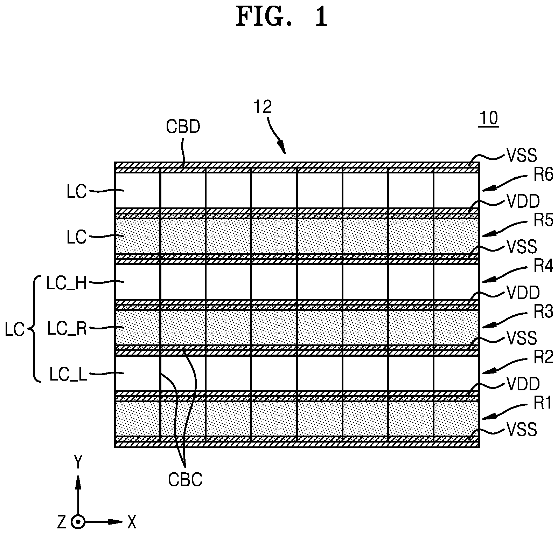

FIG. 1 is a diagram illustrating a layout of a cell block 12 of an integrated circuit device 10 according to some embodiments.

Referring to FIG. 1, the cell block 12 of the integrated circuit device 10 may include a plurality of logic cells LC that may include circuit patterns for forming various circuits on an upper surface of a substrate. The logic cells LC may be arranged in a matrix in a first horizontal direction (an X direction) and a second horizontal direction (a Y direction) in the cell block 12. The first and the second horizontal directions may be parallel to the upper surface of the substrate.

Each of the logic cells LC may include a circuit pattern having a layout designed according to a Place and Route (PnR) rule to perform at least one logical function. The logic cells LC may have various logical functions. In embodiments, the logic cells LC may include a plurality of standard cells. In embodiments, at least some of the logic cells LC may perform the same logical function. In some embodiments, at least some of the logic cells LC may perform different logical functions from each other.

The logic cells LC may include various kinds of logic cells including a plurality of circuit elements. Each of the logic cells LC may include, but not limited to, an AND gate, a NAND gate, an OR gate, a NOR gate, an exclusive OR (XOR) gate, an exclusive NOR (XNOR) gate, an inverter (INV), an adder (ADD), a buffer (BUF), a delay (DLY), a filter (FIL), a multiplexer (MXT/MXIT), an OR/AND/inverter (OAI) gate, an AND/OR (AO) gate, an AND/OR/inverter (AOI) gate, a D flip-flop, a reset flip-flop, a master-slave flip-flop, a latch, or a combination thereof.

In the cell block 12, at least some of logic cells LC that form one of first to sixth rows R1, R2, R3, R4, R5, and R6 in the first horizontal direction (the X direction) may have the same width. At least some of the logic cells LC that form one of the first to sixth rows R1, R2, R3, R4, R5, and R6 may have the same length. However, the present disclosure is not limited to FIG. 1. At least some of the logic cells LC that form one of the first to sixth rows R1, R2, R3, R4, R5, and R6 may have different widths and lengths.

The area of each of the logic cells LC of the cell block 12 of the integrated circuit device 10 may be defined by a cell boundary CBD. A cell contact portion CBC, at which cell boundaries CBD meet each other, may be between two logic cells LC adjacent to each other in the first horizontal direction (the X direction) or the second horizontal direction (the Y direction).

In some embodiments, among the logic cells LC forming one of the first to sixth rows R1, R2, R3, R4, R5, and R6, two logic cells LC adjacent to each other in the first horizontal direction (the X direction) may be in contact with each other at the cell contact portion CBC without a gap between the two logic cells LC. The term "contact," or "in contact with," as used herein, refers to a direct connection (i.e., physical touching) unless the context indicates otherwise. In some embodiments, among the logic cells LC forming one of the first to sixth rows R1, R2, R3, R4, R5, and R6, two logic cells LC adjacent to each other in the first horizontal direction (the X direction) may be spaced apart from each other.

In embodiments, among the logic cells LC forming one of the first to sixth rows R1, R2, R3, R4, R5, and R6, two adjacent logic cells LC may have the same structure and perform the same function. In some embodiments, among the logic cells LC forming one of the first to sixth rows R1, R2, R3, R4, R5, and R6, two adjacent logic cells LC may perform different functions.

In some embodiments, among the logic cells LC of the cell block 12 of the integrated circuit device 10, two logic cells LC adjacent to each other in the second horizontal direction (the Y direction) may have a symmetrical structure with respect to the cell contact portion CBC between the two logic cells LC. For example, a reference logic cell LC_R in the third row R3 and a lower logic cell LC_L in the second row R2 may have a symmetrical structure with respect to the cell contact portion CBC therebetween. The reference logic cell LC_R in the third row R3 and a higher logic cell LC_H in the fourth row R4 may have a symmetrical structure with respect to the cell contact portion CBC therebetween.

In FIG. 1, the cell block 12 may include six rows, i.e., the first to sixth rows R1, R2, R3, R4, R5, and R6. The present disclosure is not limited thereto. In some embodiments, the cell block 12 may include various numbers of rows and each row may include various numbers of logic cells to implement a desired function.

One of a plurality of ground lines VSS and power lines VDD may be arranged between two adjacent rows among the first to sixth rows R1, R2, R3, R4, R5, and R6, each including a plurality of logic cells LC arranged along a line extending in the first horizontal direction (the X direction). The ground lines VSS and the power lines VDD may extend in the first horizontal direction (the X direction) and may be alternately arranged and apart from each other in the second horizontal direction (the Y direction). Accordingly, each of the ground lines VSS and the power lines VDD may overlap the cell boundary CBD arranged in the second horizontal direction (the Y direction) of the logic cells LC.

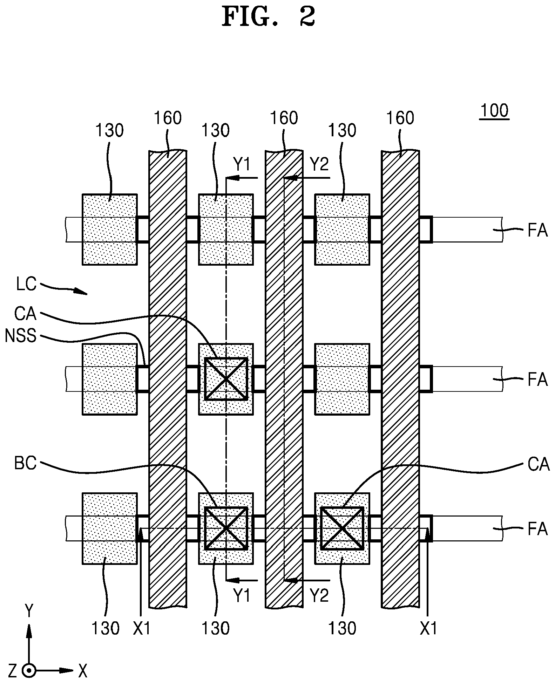

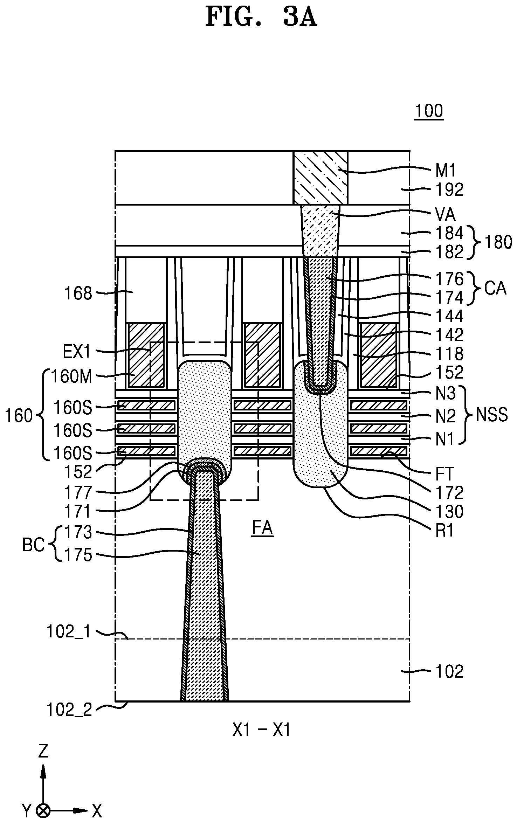

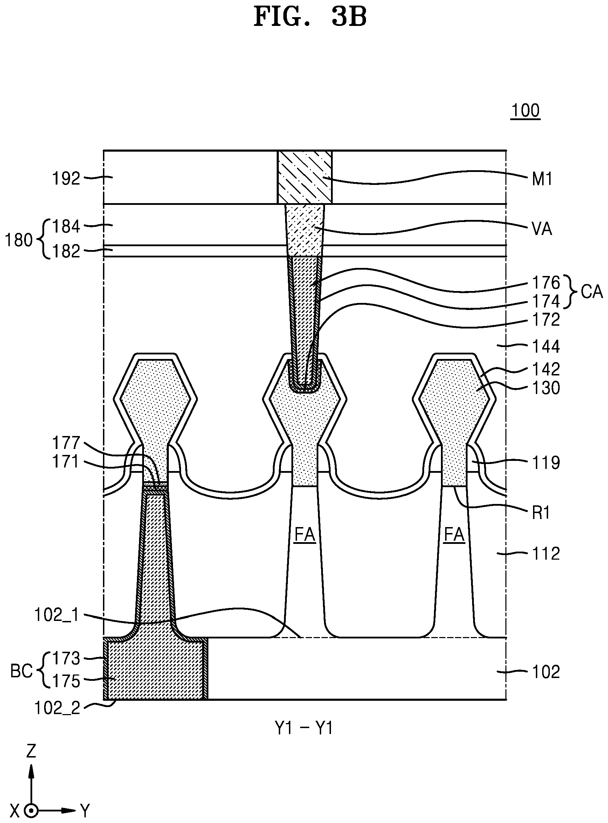

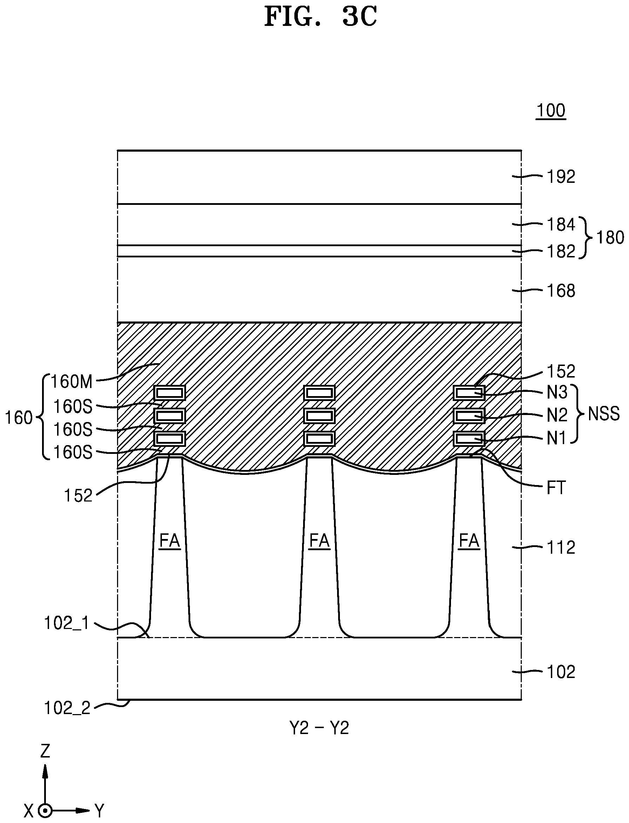

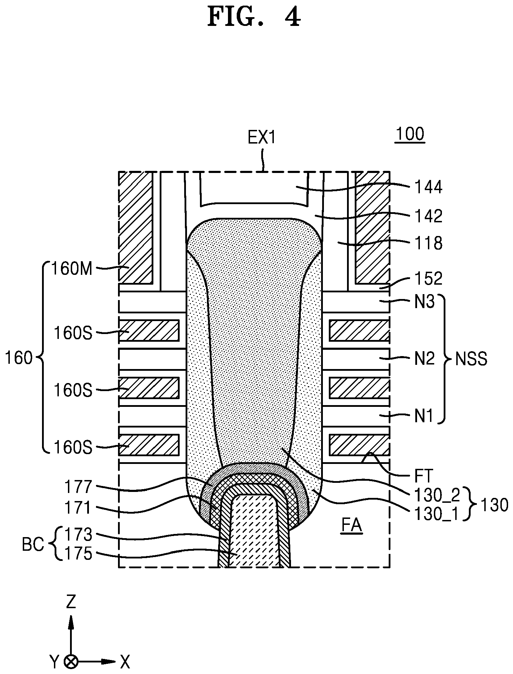

FIG. 2 is a layout diagram illustrating an integrated circuit device 100 according to some embodiments. FIGS. 3A to 3C are cross-sectional views illustrating the integrated circuit device 100 according to some embodiments. FIG. 4 is an enlarged cross-sectional view illustrating the integrated circuit device 100 according to some embodiments. FIG. 3A is a cross-sectional view taken along line X1-X1 in FIG. 2. FIG. 3B is a cross-sectional view taken along line Y1-Y1 in FIG. 2. FIG. 3C is a cross-sectional view taken along line Y2-Y2 in FIG. 2. FIG. 4 is an enlarged cross-sectional view of a region EX1 in FIG. 3A.

The integrated circuit device 100 including a field-effect transistor having a gate-all-around, which includes an active region having a nanowire or nanosheet shape and a gate surrounding the active region, is described below with reference to FIGS. 2 to 4. The integrated circuit device 100 may form some of the logic cells LC in FIG. 1.

The integrated circuit device 100 may include a substrate 102, which has a first surface 102_1 (i.e., an upper surface) and a second surface 102_2 (i.e., a lower surface), and a plurality of fin-type active regions FA protruding from the first surface 102_1 of the substrate 102. The fin-type active regions FA may extend lengthwise in a first horizontal direction (the X direction) to be parallel with each other on the substrate 102.

The substrate 102 may include or may be formed of a semiconductor material, such as Si and Ge, or a compound semiconductor, such as SiGe, SiC, GaAs, InAs, InGaAs, and InP. Each of the terms "SiGe", "SiC", "GaAs", "InAs", "InGaAs", and "InP" used herein indicates a material composed of elements included in each term and is not a chemical equation representing stoichiometric relationships. The substrate 102 may include a conductive region, e.g., an impurity-doped well or an impurity-doped structure.

An isolation film 112 may be in a trench isolation structure defining the fin-type active regions FA. The isolation film 112 may cover a portion of a sidewall of each of the fin-type active regions FA. The isolation film may be connected to the upper surface of the substrate 102 as shown in FIG. 3B. The present disclosure is not limited thereto. In some embodiments, the isolation film 112 may be spaced apart from the substrate 102 in a vertical direction (a Z direction). The vertical direction may be perpendicular to the first surface 102_1 of the substrate 102. The isolation film 112 may include or may be a silicon oxide film. The isolation film 112 may include a material having etch selectivity with respect to a material of the substrate 102.

As shown in FIGS. 2, 3A, and 3C, a plurality of gate lines 160 may be disposed on the fin-type active regions FA. Each of the gate lines 160 may extend lengthwise in a second horizontal direction (the Y direction) that crosses the first horizontal direction (the X direction). Each of a plurality of nanosheet stacks NSS may be disposed above a fin top FT (i.e., a top surface) of a fin-type active region FA where the fin-type active region FA intersects with one of the gate lines 160. Each of the nanosheet stacks NSS may include at least one nanosheet, which faces or is adjacent to the fin top FT of the fin-type active region FA at a position separated in the vertical direction (the Z direction) from the fin top FT of the fin-type active region FA. It will be understood that the nanosheet may comprise a nanowire.

As shown in FIGS. 3A and 3C, each of the nanosheet stacks NSS may include a first nanosheet N1, a second nanosheet N2, and a third nanosheet N3, which overlap each other above the fin-type active region FA in the vertical direction (the Z direction). The first nanosheet N1, the second nanosheet N2, and the third nanosheet N3 may have different vertical distances (Z-direction distances) from the fin top FT of the fin-type active region FA. Each of the gate lines 160 may surround the first nanosheet N1, the second nanosheet N2, and the third nanosheet N3 of a nanosheet stack NSS, which overlap each other in the vertical direction (the Z direction).

Although the planar shape of the nanosheet stack NSS is a substantially rectangular shape in FIG. 2, embodiments are not limited thereto. The nanosheet stack NSS may have various planar shapes according to the planar shape of each of the fin-type active region FA and the gate lines 160. The present embodiment illustrates a configuration in which the plurality of gate lines 160 are arranged on one fin-type active region FA and the nanosheet stack NSS is arranged on the one fin-type active region FA in line in the first horizontal direction (the X direction). For example, the nanosheet stack NSS may be disposed on an upper surface of the fin-type active region FA, and may extend lengthwise along an extension direction (e.g., the first horizontal direction) of the fin-type active region FA. The numbers of nanosheet stacks NSS and gate lines 160, which are arranged on one fin-type active region FA, are not particularly limited.

Each of the first nanosheet N1, the second nanosheet N2, and the third nanosheet N3 of the nanosheet stack NSS may function as a channel region. In some embodiments, each of the first nanosheet N1, the second nanosheet N2, and the third nanosheet N3 may have, but not limited to, a thickness selected from a range from about 4 nm to about 6 nm. The thickness of each of the first nanosheet N1, the second nanosheet N2, and the third nanosheet N3 refers to a size in the vertical direction (the Z direction). In some embodiments, the first nanosheet N1, the second nanosheet N2, and the third nanosheet N3 may have substantially the same thickness as one another in the vertical direction (the Z direction). In some embodiments, at least some of the first nanosheet N1, the second nanosheet N2, and the third nanosheet N3 may have different thicknesses from other nanosheets in the vertical direction (the Z direction). In some embodiments, each of the first nanosheet N1, the second nanosheet N2, and the third nanosheet N3 of the nanosheet stack NSS may include or may be formed of an Si layer, an SiGe layer, or a combination thereof.

As shown in FIG. 3A, the first nanosheet N1, the second nanosheet N2, and the third nanosheet N3 of one nanosheet stack NSS may have the same or similar sizes in the first horizontal direction (the X direction). In some embodiments, unlike FIG. 3, at least some of the first nanosheet N1, the second nanosheet N2, and the third nanosheet N3 of one nanosheet stack NSS may have different sizes from other nanosheets in the first horizontal direction (the X direction). Each of the nanosheet stacks NSS includes three nanosheets. The present disclosure is not limited thereto. For example, a nanosheet stack NSS may include at least one nanosheet, and the number of nanosheets forming the nanosheet stack NSS is not particularly limited.

As shown in FIGS. 3A and 3C, each of the gate lines 160 may include a main gate portion 160M and a plurality of sub gate portions 160S. The main gate portion 160M may extend lengthwise in the second horizontal direction (the Y direction) to cover the top surface of the nanosheet stack NSS. The sub gate portions 160S may be integrally connected to the main gate portion 160M and respectively between the third nanosheet N3 and the second nanosheet N2, between the second nanosheet N2 and the first nanosheet N1, and between the first nanosheet N1 and the fin-type active region FA. In the vertical direction (the Z direction), the thickness of each of the sub gate portions 160S may be less than the thickness of the main gate portion 160M.

Each of the gate lines 160 may include or may be formed of metal, metal nitride, metal carbide, or a combination thereof. The metal may be selected from Ti, W, Ru, Nb, Mo, Hf, Ni, Co, Pt, Yb, Tb, Dy, Er, and Pd. The metal nitride may be selected from TiN and TaN. The metal carbide may include TiAlC. However, the material of the gate lines 160 is not limited to those described above.

As shown in FIGS. 3A and 3B, a plurality of first recesses R1 may be formed in the fin-type active region FA. The vertical level of the bottommost surface of each of the first recesses R1 may be lower than the vertical level of the fin top FT of the fin-type active region FA.

As shown in FIGS. 3A and 3B, a plurality of source/drain regions 130 may be respectively arranged in the first recesses R1. Each of the source/drain regions 130 may be adjacent to at least one of the gate lines 160. Each of the source/drain regions 130 may have surfaces respectively facing the first nanosheet N1, the second nanosheet N2, and the third nanosheet N3, which are included in a corresponding nanosheet stack NSS which is adjacent to each source/drain region 130. For example, each of the source/drain regions 130 may have a side surface that is adjacent to the first to third nanosheets N1 to N3 of a corresponding nanosheet stack NSS. Each of the source/drain regions 130 may be in contact with the first nanosheet N1, the second nanosheet N2, and the third nanosheet N3, which are included in a nanosheet stack NSS adjacent to each source/drain region 130.

A gate dielectric film 152 may be disposed in a space between a nanosheet stack NSS and a gate line 160. In some embodiments, the gate dielectric film 152 may include a stack structure of an interface dielectric film and a high-k dielectric film. The interface dielectric film may include or may be formed of a low-k dielectric film, e.g., a silicon oxide film, a silicon oxynitride film, or a combination thereof, having a permittivity of about 9 or less. In some embodiments, the interface dielectric film may be omitted. The high-k dielectric film may include or may be formed of a material having a higher dielectric constant than a silicon oxide film. For example, the high-k dielectric film may have a dielectric constant of about 10 to about 25. The high-k dielectric film may include or may be formed of hafnium oxide but is not limited thereto.

As shown in FIGS. 3A and 3C, the top surface of each of the gate dielectric film 152 and the gate line 160 may be covered with a capping insulating pattern 168. The capping insulating pattern 168 may include or may be a silicon nitride film.

Opposite sidewalls of each of the gate line 160 and the capping insulating pattern 168 may be respectively covered with outer insulating spacers 118. The outer insulating spacers 118 may be disposed above the top surface of the nanosheet stacks NSS to respectively cover the opposite side walls of the main gate portion 160M. The outer insulating spacers 118 may be separated from the gate line 160 by the gate dielectric film 152.

As shown in FIG. 3B, a plurality of recess insulating spacers 119 may be disposed on the top surface of the isolation film 112 to respectively cover the sidewalls of the source/drain region 130. In some embodiments, each of the recess insulating spacers 119 may be integrally connected to the outer insulating spacer 118 adjacent to each recess insulating spacer 119.

The outer insulating spacers 118 and the recess insulating spacers 119 may include or may be formed of silicon nitride, silicon oxide, SiCN, SiBN, SiON, SiOCN, SiBCN, SiOC, or a combination thereof. Each of the terms "SiCN", "SiBN", "SiON", "SiOCN", "SiBCN", and "SiOC" used herein indicates a material composed of elements included in each term and is not a chemical equation representing stoichiometric relationships.

A first metal silicide film 172 may be disposed on the top surface of some source/drain regions 130. The first metal silicide film 172 may include or may be formed of metal including Ti, W, Ru, Nb, Mo, Hf, Ni, Co, Pt, Yb, Tb, Dy, Er, or Pd. For example, the first metal silicide film 172 may include or may be formed of titanium silicide but is not limited thereto.

A plurality of source/drain regions 130, a plurality of first metal silicide films 172, and a plurality of outer insulating spacers 118 may be disposed on the substrate 102, and may be covered with an insulating liner 142. In some embodiments, the insulating liner 142 may be omitted. An intergate insulating film 144 may be disposed on the insulating liner 142. When the insulating liner 142 is omitted, the intergate insulating film 144 may be in contact with the source/drain regions 130.

The insulating liner 142 and the intergate insulating film 144 may be sequentially arranged on the source/drain regions 130 and the first metal silicide films 172. The insulating liner 142 and the intergate insulating film 144 may form an insulating structure. In some embodiments, the insulating liner 142 may include or may be formed of, but not limited to, silicon nitride, SiCN, SiBN, SiON, SiOCN, SiBCN, or a combination thereof. The intergate insulating film 144 may include or may be a silicon oxide film but is not limited thereto.

Each of the opposite sidewalls of each of the sub gate portions 160S of each of the gate lines 160 may be separated from one of the source/drain regions 130 by the gate dielectric film 152. The gate dielectric film 152 may be disposed in a space between each of the sub gate portions 160S of each gate line 160 and one of the first nanosheet N1, the second nanosheet N2, and the third nanosheet N3 and between the sub gate portions 160S of the gate line 160 and the source/drain region 130.

Each of the nanosheet stacks NSS may be disposed above the fin top FT of the fin-type active region FA where the fin-type active region FA intersects with one of the gate lines 160 and may face or may be adjacent to the fin top FT of the fin-type active region FA at a position separated from the fin-type active region FA. A plurality of nanosheet transistors may be formed above the substrate 102 where fin-type active regions FA intersect with the gate lines 160.

As shown in FIGS. 3A and 3B, an active contact CA may be disposed on the source/drain region 130. The active contact CA may pass through the intergate insulating film 144 and the insulating liner 142 in the vertical direction (the Z direction) and may be in contact with the first metal silicide film 172. The active contact CA may be electrically connected to the source/drain region 130 through the first metal silicide film 172.

The active contact CA may include a conductive barrier pattern 174 and a contact plug 176, which are sequentially stacked on the source/drain region 130. The conductive barrier pattern 174 may surround and may be in contact with the bottom surface and sidewall of the contact plug 176. The active contact CA may extend lengthwise in the vertical direction (the Z direction) through the intergate insulating film 144 and the insulating liner 142. The conductive barrier pattern 174 may be disposed in a space between the first metal silicide film 172 and the contact plug 176. The conductive barrier pattern 174 may have a surface which is in contact with the first metal silicide film 172 and a surface which is in contact with the contact plug 176. In some embodiments, the conductive barrier pattern 174 may include or may be formed of metal or metal nitride. For example, the conductive barrier pattern 174 may include or may be formed of, but not limited to, Ti, Ta, W, TiN, TaN, WN, WCN, TiSiN, TaSiN, WSiN, or a combination thereof. The contact plug 176 may include or may be formed of, but not limited to, molybdenum (Mo), copper (Cu), tungsten (W), cobalt (Co), ruthenium (Ru), manganese (Mn), titanium (Ti), tantalum (Ta), aluminum (Al), or a combination thereof.

As shown in FIGS. 3A to 3C, the top surfaces of the active contact CA, the capping insulating pattern 168, and the intergate insulating film 144 may be covered with an upper insulating structure 180. The upper insulating structure 180 may include an etch stop film 182 and an interlayer insulating film 184, which are sequentially stacked on the active contact CA, the capping insulating pattern 168, and the intergate insulating film 144. The etch stop film 182 may include or may be formed of silicon carbide (SiC), silicon nitride (SiN), nitrogen-doped silicon carbide (SiC:N), SiOC, AlN, AlON, AlO, AlOC, or a combination thereof. The interlayer insulating film 184 may include or may be an oxide film, a nitride film, an ultra low-k (ULK) film having an ultra low dielectric constant K of about 2.2 to about 2.4, or a combination thereof. For example, the interlayer insulating film 184 may include or may be formed of, but not limited to, a tetraethylorthosilicate (TEOS) film, a high density plasma (HDP) oxide film, a boro-phosphosilicate glass (BPSG) film, a flowable chemical vapor deposition (FCVD) oxide film, a SiON film, a SiN film, a SiOC film, a SiCOH film, or a combination thereof.

As shown in FIGS. 3A and 3B, a via contact VA may be disposed on the active contact CA. The via contact VA may pass through the upper insulating structure 180 and may be in contact with the active contact CA. The source/drain region 130 may be electrically connected to the via contact VA through the first metal silicide film 172 and the active contact CA. The bottom surface of the via contact VA may be in contact with the top surface of the active contact CA. The via contact VA may include or may be formed of, but not limited to, W, Mo, and/or Ru.

An interconnection line M1 may pass through an upper insulating film 192. The interconnection line M1 may be connected to the via contact VA therebelow. In some embodiments, the interconnection line M1 may extend in the first horizontal direction (the X direction). The interconnection line M1 may include or may be formed of, but not limited to, Mo, Cu, W, Co, Ru, Mn, Ti, Ta, Al, or a combination thereof.

As shown in FIGS. 3A and 3B, a backside contact BC may pass through the substrate 102 and may be in contact with the source/drain region 130. The backside contact BC may pass through the substrate 102 and the fin-type active region FA in the vertical direction (the Z direction) and may be in contact with a second metal silicide film 171. The backside contact BC may be electrically connected to the source/drain region 130 through the second metal silicide film 171. In some embodiments, the backside contact BC may extend from the second surface 102_2 of the substrate toward a lower portion of the source/drain region 130. The second metal silicide film 171 may be disposed in a space between the lower portion of the source/drain region 130 and an upper portion of the backside contact BC. The upper portion of the backside contact BC may contact the second metal silicide film 171 and may be connected to the source/drain region 130.

The backside contact BC may include a barrier pattern 173 and a conductive plug 175, which are sequentially stacked. The barrier pattern 173 may surround and may be in contact with the sidewall and top surface of the conductive plug 175. The barrier pattern 173 may be between the second metal silicide film 171 and the conductive plug 175. The barrier pattern 173 may have a surface which is in contact with the second metal silicide film 171 and a surface which is in contact with the conductive plug 175.

In some embodiments, the barrier pattern 173 may include or may be formed of metal or metal nitride. For example, the barrier pattern 173 may include or may be formed of, but not limited to, Ti, Ta, W, TiN, TaN, WN, WCN, TiSiN, TaSiN, WSiN, or a combination thereof. The contact plug 175 may include or may be formed of, but not limited to, Mo, Cu, W, Co, Ru, Mn, Ti, Ta, Al, or a combination thereof.

A high-concentration doped layer 177 may be disposed in a space between the source/drain region 130 and the backside contact BC. The backside contact BC may be inserted into the source/drain region 130. The high-concentration doped layer 177 may be disposed in a space between the inserted portion (i.e., an upper portion) of the backside contact BC and the source/drain region 130. In some embodiments, the high-concentration doped layer 177 may correspond to a lower portion of the source/drain region 130, which is doped at a higher concentration than the other portion of the source/drain region 130. The high-concentration doped layer 177 is described in detail with reference to FIG. 4.

In some embodiments, the second metal silicide film 171 may be disposed in a space between the high-concentration doped layer 177 and the backside contact BC (e.g., the upper portion of the backside contact BC). The second metal silicide film 171 may be in contact with the high-concentration doped layer 177. The second metal silicide film 171 may include or may be formed of metal including Ti, W, Ru, Nb, Mo, Hf, Ni, Co, Pt, Yb, Tb, Dy, Er, or Pd. For example, the second metal silicide film 171 may include or may be formed of titanium silicide but is not limited thereto.

Referring to FIG. 4, between the inserted portion of the backside contact BC (i.e., the upper portion of the backside contact BC) and the source/drain region 130, the second metal silicide film 171 and the high-concentration doped layer 177 may be sequentially arranged. The second metal silicide film 171 may be disposed between the backside contact BC and the high-concentration doped layer 177 and may be in contact with the high-concentration doped layer 177. The second metal silicide film 171 and the high-concentration doped layer 177 may conformally cover the top surface of an upper portion of the backside contact BC. The second metal silicide film 171 and the high-concentration doped layer 177 may have a convex shape into the source/drain region 130. In some embodiments, the high-concentration doped layer 177 may correspond to a lower portion of the source/drain region 130, and the second metal silicide film 171 may be disposed in a space between the high-concentration doped layer 177 and the upper portion of the backside contact BC.

In some embodiments, the source/drain region 130 may include a first semiconductor layer 130_1 and a second semiconductor layer 130_2, which are sequentially stacked. The first semiconductor layer 130_1 may be disposed on the bottom surface of a first recess R1 and may be in contact with the fin-type active region FA and a channel region. The second semiconductor layer 130_2 may be disposed on the first semiconductor layer 130_1 and may completely fill the first recess R1. For example, the first semiconductor layer 130_1 and the second semiconductor layer 130_2 may be in contact with the high-concentration doped layer 177.

In the source/drain region 130, each of the first semiconductor layer 130_1 and the second semiconductor layer 130_2 may include or may be an Si₁₋ₓGeₓ layer doped with a p-type dopant, where x is a positive fractional number greater than 0. The Ge content in the first semiconductor layer 130_1 may be less than the Ge content in the second semiconductor layer 130_2.

For example, the Ge content in the first semiconductor layer 130_1 may be greater than 0 at% and less than about 10 at%. The Ge content in the second semiconductor layer 130_2 may be greater than about 45 at% and less than about 60 at%.

In some embodiments, a p-type dopant concentration in the first semiconductor layer 130_1 may be less than a p-type dopant concentration in the second semiconductor layer 130_2. For example, the p-type dopant concentration in the first semiconductor layer 130_1 may be about 1×10¹⁸ atom/cm³ to about 1×10¹⁹ atom/cm³. The p-type dopant concentration in the second semiconductor layer 130_2 may be about 1×10²⁰ atom/cm³ to about 5×10²⁰ atom/cm³.

The p-type dopant included in the source/drain region 130 may include, but not limited to, boron (B), gallium (Ga), carbon (C), or a combination thereof.

In some embodiments, the high-concentration doped layer 177 may include an Si₁₋ₓGeₓ layer doped with a p-type dopant, where x is a positive fractional number greater than 0. For example, the Ge content in the high-concentration doped layer 177 may be about 45 at% to about 70 at%.

In embodiments, the high-concentration doped layer 177 may have a greater p-type dopant concentration than the source/drain region 130. For example, the high-concentration doped layer 177 may have a greater p-type dopant concentration than the first semiconductor layer 130_1 and the second semiconductor layer 130_2. For example, the p-type dopant concentration in the high-concentration doped layer 177 may be about 5×10²⁰ atom/cm³ to about 1×10²² atom/cm³.

In some embodiments, the p-type dopant included in the high-concentration doped layer 177 may include, but not limited to, boron (B), gallium (Ga), carbon (C), or a combination thereof.

When the integrated circuit device 100 includes the high-concentration doped layer 177 that is in contact with the second metal silicide film 171 and has a greater dopant concentration than the source/drain region 130 (e.g., the first and second semiconductor layers 130_1 and 130_2), a contact resistance between the source/drain region 130 and the backside contact BC may be lowered. For example, as the high-concentration doped layer 177 has a greater dopant concentration than the source/drain region 130, the resistance of the backside contact BC may be lowered by decreasing a Schottky barrier at the interface between the second metal silicide film 171 and the high-concentration doped layer 177.

In some embodiments, the high-concentration doped layer 177 may further include a Ga dopant. For example, a Ga dopant concentration in the high-concentration doped layer 177 may be lower than the p-type dopant concentration in the high-concentration doped layer 177. For example, the high-concentration doped layer 177 may further include a Ga dopant with a lower concentration than a concentration of the p-type dopant.

According to the present disclosure, as the high-concentration doped layer 177 of the integrated circuit device 100 further includes a Ga dopant, the high-concentration doped layer 177 may further provide a diffusion prevention effect. For example, as the high-concentration doped layer 177 further includes a Ga dopant that is larger than a B dopant, diffusion of the Ga dopant in the high-concentration doped layer 177 may be prevented.

In some embodiments, the high-concentration doped layer 177 of the integrated circuit device 100 may have a Ge content that is greater than or equal to the Ge content in the source/drain region 130. For example, the Ge content in the high-concentration doped layer 177 may be about 45 at% to about 70 at%. In some embodiments, the high-concentration doped layer 177 of the integrated circuit device 100 may include more Ge content, which is larger than Si content, than the source/drain region 130, thereby further providing a stress boosting effect. For example, the high-concentration doped layer 177 with higher Ge content may exert a stress (e.g., a compressive stress) on the first to third nanosheets N1, N2, and N3, thereby increasing mobility of holes when the nanosheets serve as a channel region of p-type MOS transistor. Accordingly, a channel resistance characteristic may be improved.

FIGS. 2 to 4 may disclose the integrated circuit device 100 having increased performance and/or reliability.

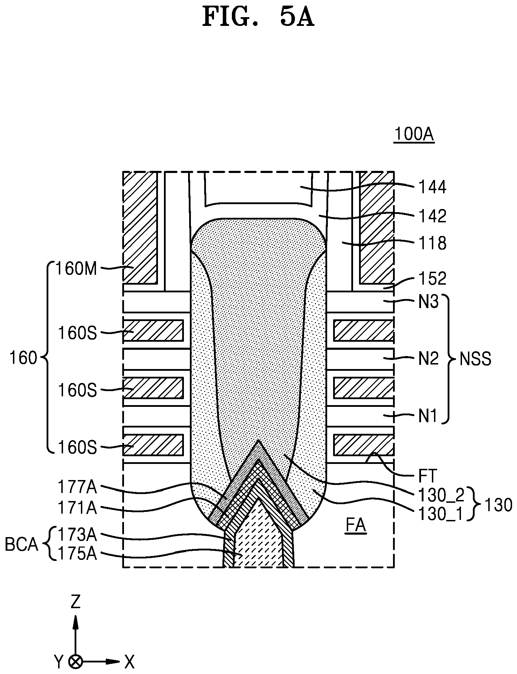

FIGS. 5A to 5C are enlarged cross-sectional views illustrating integrated circuit devices 100A, 100B, and 100C according to some embodiments. The integrated circuit devices 100A, 100B, and 100C are described below, focusing on the differences from the integrated circuit device 100 described above with reference to FIGS. 2 to 4.

Referring to FIG. 5A, the integrated circuit device 100A may include a high-concentration doped layer 177A between the source/drain region 130 and a backside contact BCA. The backside contact BCA may include a barrier pattern 173A and a conductive plug 175A, which are sequentially stacked. The integrated circuit device 100A may further include a second silicide film 171A between the high-concentration doped layer 177A and the backside contact BCA. The second silicide film 171A may be in contact with the high-concentration doped layer 177A.

In embodiments, the high-concentration doped layer 177A may have a pointy shape. For example, the boundary between the high-concentration doped layer 177A and the source/drain region 130 may have a triangular shape. To form the pointy shape of the high-concentration doped layer 177A, etching conditions may be adjusted in a process of etching a portion of the source/drain region 130 to form the high-concentration doped layer 177A. For example, the pointy shape of the high-concentration doped layer 177A may be formed by adjusting an etch rate according to a crystal face.

In FIG. 5A, the top surface of each of the second silicide film 171A which is disposed on the high-concentration doped layer 177A and the backside contact BCA has a triangular shape. The shape of the top surface of each of the second silicide film 171A and the backside contact BCA is not limited thereto. For example, the second silicide film 171A and the backside contact BCA may each conformally cover the high-concentration doped layer 177A.

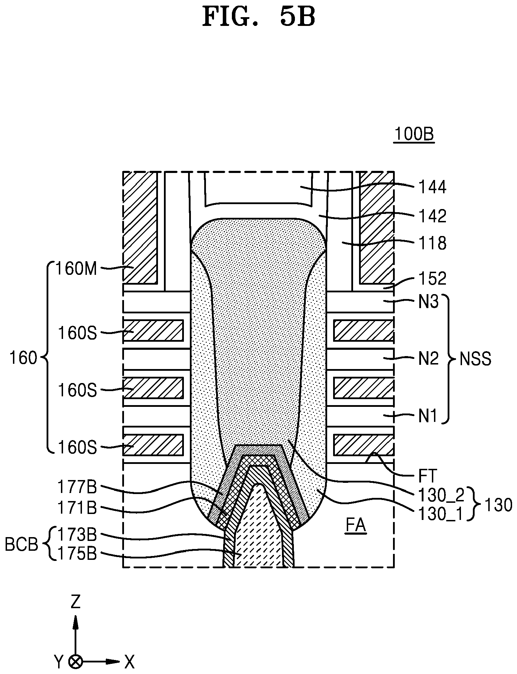

Referring to FIG. 5B, the integrated circuit device 100B may include a high-concentration doped layer 177B between the source/drain region 130 and a backside contact BCB. The backside contact BCB may include a barrier pattern 173B and a conductive plug 175B, which are sequentially stacked. The integrated circuit device 100B may further include a second silicide film 171B between the high-concentration doped layer 177B and the backside contact BCB. The second silicide film 171B may be in contact with the high-concentration doped layer 177B.

In some embodiments, the high-concentration doped layer 177B may have a trapezoidal shape. For example, the boundary between the high-concentration doped layer 177B and the source/drain region 130 may have a trapezoidal shape.

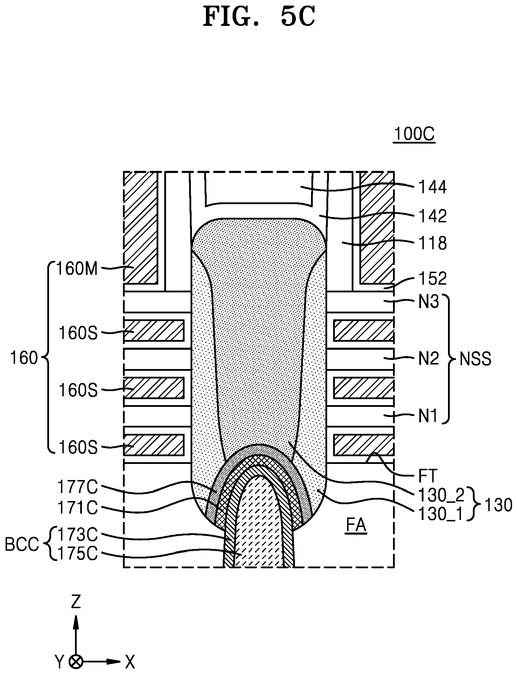

Referring to FIG. 5C, the integrated circuit device 100C may include a high-concentration doped layer 177C between the source/drain region 130 and a backside contact BCC. The backside contact BCC may include a barrier pattern 173C and a conductive plug 175C, which are sequentially stacked. The integrated circuit device 100C may further include a second silicide film 171C between the high-concentration doped layer 177C and the backside contact BCC. The second silicide film 171C may be in contact with the high-concentration doped layer 177C.

In some embodiments, the high-concentration doped layer 177C may overlap a gate line 160 in the first horizontal direction (the X direction). Compared to the high-concentration doped layer 177 of the integrated circuit device 100 as described with reference to FIGS. 2 to 4, the backside contact BCC may further penetrate the source/drain region 130 such that the high-concentration doped layer 177C may be arranged to overlap the gate line 160 in the first horizontal direction (the X direction).

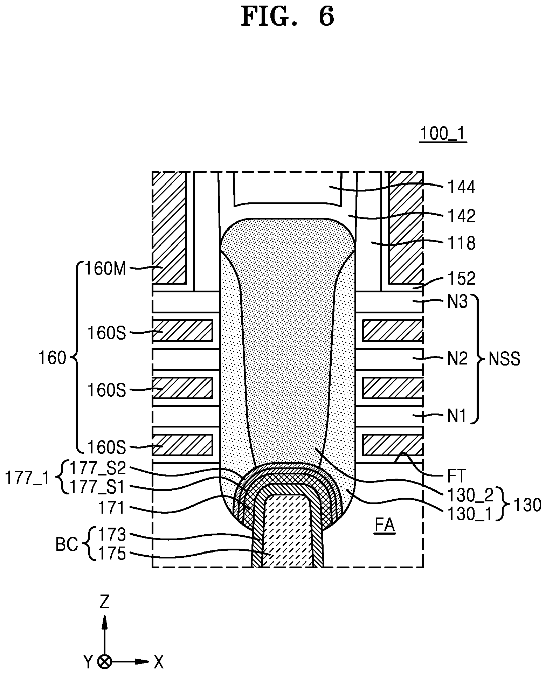

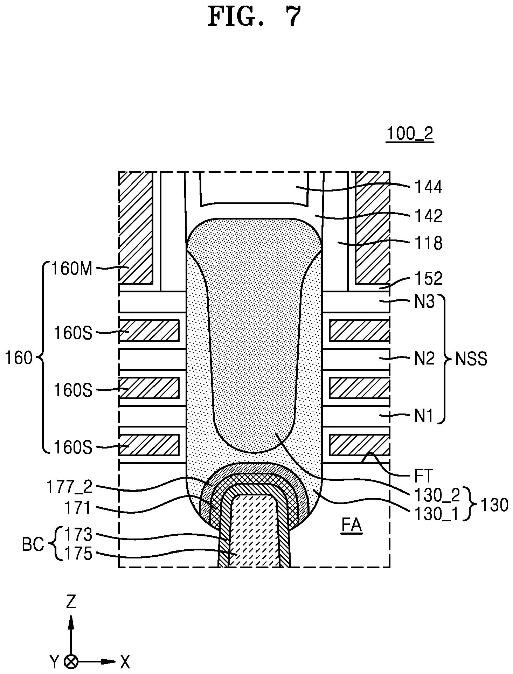

FIGS. 6 and 7 are enlarged cross-sectional views illustrating integrated circuit devices 100_1 and 100_2 according to some embodiments. The integrated circuit devices 100_1 and 100_2 are described below, focusing on the differences from the integrated circuit device 100 as described above with reference to FIGS. 2 to 4.

Referring to FIG. 6, the integrated circuit device 100_1 may include a high-concentration doped layer 177_1 between the source/drain region 130 and the backside contact BC. The integrated circuit device 100_1 may include the second metal silicide film 171 between the high-concentration doped layer 177_1 and the backside contact BC. The second metal silicide film 171 may be in contact with the high-concentration doped layer 177_1.

In some embodiments, the high-concentration doped layer 177_1 may have a stack structure of a first sub high-concentration doped layer 177_S1 and a second sub high-concentration doped layer 177_S2. Each of the first sub high-concentration doped layer 177_S1 and the second sub high-concentration doped layer 177_S2 may include an Si₁₋ₓGeₓ layer doped with a p-type dopant, where x is a positive fractional number greater than 0.

In some embodiments, the first sub high-concentration doped layer 177_S1 and the second sub high-concentration doped layer 177_S2 may differ in at least one selected from the group consisting of a Ge content, the type of p-type dopant, and the concentration of the p-type dopant. For example, the first sub-high-concentration doped layer 177_S1 and the second sub-high-concentration doped layer 177_S2 may each include a B-dopant (i.e., a dopant of boron) but may have different concentrations of the B-dopants. For example, the first sub high-concentration doped layer 177_S1 may include a B-dopant and the second sub high-concentration doped layer 177_S2 may include a B-dopant and a Ga-dopant (i.e., a dopant of gallium).

Referring to FIG. 7, the integrated circuit device 100_2 may include a high-concentration doped layer 177_2 between the source/drain region 130 and the backside contact BC. The integrated circuit device 100_2 may include the second metal silicide film 171 between the high-concentration doped layer 177_2 and the backside contact BC. The second metal silicide film 171 may be in contact with the high-concentration doped layer 177_2.

In some embodiments, the high-concentration doped layer 177_2 may be in contact with the source/drain region 130. For example, the high-concentration doped layer 177_2 may be in contact with the first semiconductor layer 130_1 of the source/drain region 130 but not the second semiconductor layer 130_2 of the source/drain region 130.

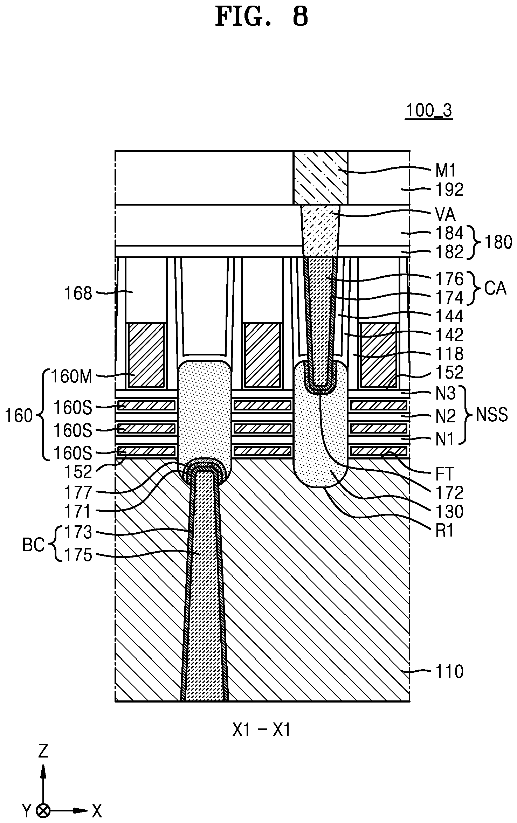

FIG. 8 is a cross-sectional view illustrating an integrated circuit device 100_3 according to some embodiments. The integrated circuit device 100_3 is described below, focusing on the differences from the integrated circuit device 100 as described above with reference to FIGS. 2 to 4.

Referring to FIG. 8, the integrated circuit device 100_3 may include an insulating layer 110 and the backside contact BC, which penetrates the insulating layer 110 and is connected to the source/drain region 130. The insulating layer 110 of the integrated circuit device 100_3 may be formed by completely removing a semiconductor material of the substrate 102 and the fin-type active region FA of the integrated circuit device 100 and replacing the semiconductor material with an insulating material. For example, the insulating layer 110 may include or may be formed of the same material as the isolation film 112. For example, the insulating material 110 may include or may be formed of a different material than the isolation film 112. The insulating material 110 may include or may be formed of at least one selected from the group consisting of silicon oxide (SiO₂), silicon nitride (SiN), silicon carbonitride (SiCN), silicon oxynitride (SiON), silicon oxycarbide (SiOC), and silicon oxycarbonitride (SiOCN).

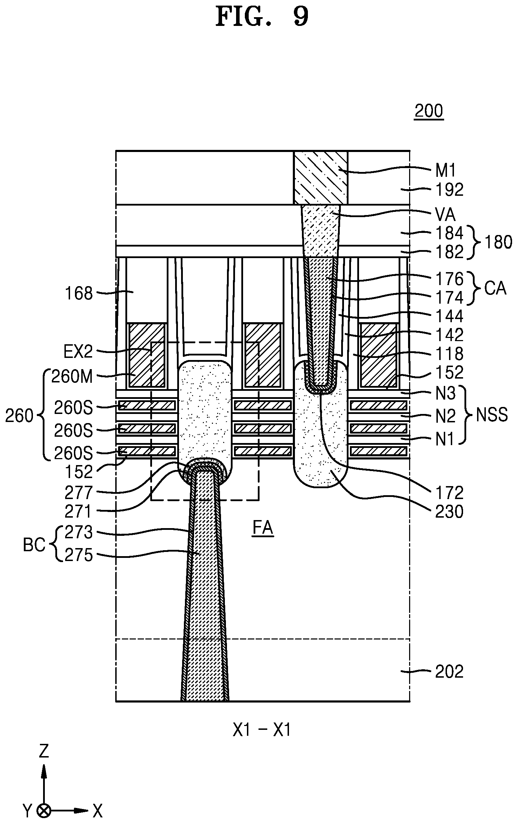

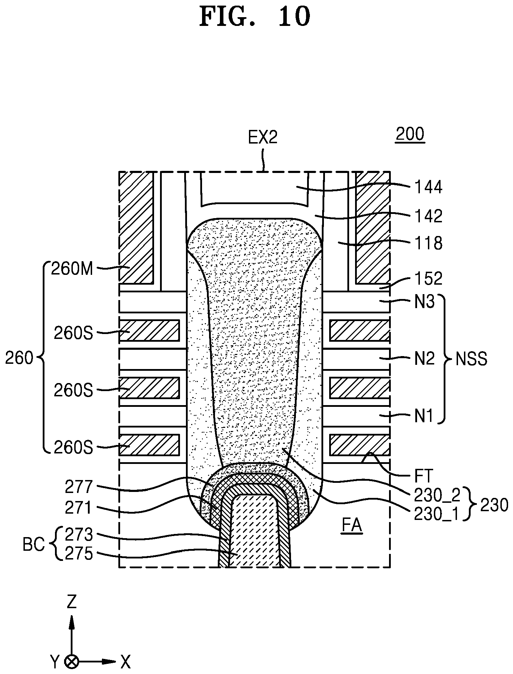

FIG. 9 is a cross-sectional view illustrating an integrated circuit device 200 according to some embodiments. FIG. 10 is an enlarged cross-sectional view illustrating the integrated circuit device 200 according to some embodiments. FIG. 10 is an enlarged cross-sectional view of a region EX2 in FIG. 9. The integrated circuit device 200 is described below, focusing on the differences from the integrated circuit device 100 as described above with reference to FIGS. 2 to 4.

Referring to FIGS. 9 and 10, the integrated circuit device 200 may include a substrate 202 and a fin-type active region FA, which protrudes from the substrate 202 and extends in the first horizontal direction (the X direction). A gate line 260 may be disposed above the fin-type active region FA and may extend in the second horizontal direction (the Y direction). A nanosheet stack NSS including a plurality of nanosheets, e.g., first to third nanosheets N1, N2, and N3, may be disposed above the fin top FT of the fin-type active region FA. The gate line 260 may include a main gate portion 260M and a plurality of sub gate portions 260S.

In some embodiments, a plurality of source/drain regions 230 may be disposed on the fin-type active region FA and arranged among a plurality of gate lines 260 such that each of the source/drain regions 230 may have surfaces facing the first nanosheet N1, the second nanosheet N2, and the third nanosheet N3, which are included in a corresponding nanosheet stack NSS that is adjacent to each source/drain region 230. For example, each of the source/drain regions 230 may have side surfaces that are adj acent to the first to third nanosheets N1 to N3 of a corresponding nanosheet stack NSS.

In some embodiments, the source/drain region 230 may include a first semiconductor layer 230_1 and a second semiconductor layer 230_2, which are sequentially stacked. The first semiconductor layer 230_1 may be in contact with the fin-type active region FA and a channel region. The second semiconductor layer 230_2 may be disposed on the first semiconductor layer 230_1. In some embodiments, the first semiconductor layer 230_1 may be disposed in a space between the second semiconductor layer 230_2 and a side surface of the nanosheet stack NSS.

In the source/drain region 230, each of the first semiconductor layer 230_1 and the second semiconductor layer 230_2 may include or may be formed of an Si layer doped with an n-type dopant.

In some embodiments, an n-type dopant concentration in the first semiconductor layer 230_1 may be less than n-type dopant concentration in the second semiconductor layer 230_2. For example, the n-type dopant concentration in the first semiconductor layer 230_1 may be less than 10²¹ atom/cm³. The n-type dopant concentration in the second semiconductor layer 230_2 may be about 10²¹ atom/cm³ to about 10²² atom/cm ³.

The n-type dopant included in the source/drain region 230 may include, but not limited to, phosphorous (P), arsenic (As), or a combination thereof.

In some embodiments, the backside contact BC may penetrate through the substrate 202 and into the source/drain region 230. In some embodiment, the backside contact BC may extend from a lower surface of the substrate 202 toward a lower portion of the source/drain region 230. The backside contact BC may include a barrier pattern 273 and a conductive plug 275, which are sequentially stacked. A high-concentration doped layer 277 may be between the backside contact BC and the source/drain region 230. The high-concentration doped layer 277 may be in contact with the first semiconductor layer 230_1 and the second semiconductor layer 230_2.

In some embodiments, the high-concentration doped layer 277 may include or may be formed of an Si layer doped with an n-type dopant. In some embodiments, the high-concentration dope layer 277 may correspond to a lower portion of the source/drain region 230 which is doped at a higher concentration than other region of the source/drain region 230. The high-concentration doped layer 277 may have a greater n-type dopant concentration than the source/drain region 230. For example, the high-concentration doped layer 277 have a greater n-type dopant concentration than the first semiconductor layer 230_1 and the second semiconductor layer 230_2. For example, the n-type dopant concentration in the high-concentration doped layer 277 may be about 1.5×10²¹ atom/cm³ to about 1×10²² atom/cm³.

The n-type dopant included in the high-concentration doped layer 277 may include, but not limited to, P, As, or a combination thereof.

For example, the high-concentration doped layer 277 may include SiP, and a P dopant concentration in the high-concentration doped layer 277 may be about 1.5×10²¹ atom/cm³ to about 1×10²² atom/cm³. For example, the high-concentration doped layer 277 may include SiAs, and an As dopant concentration in the high-concentration doped layer 277 may be about 1.5×10²¹ atom/cm³ to about 1×10²² atom/cm³. For example, the high-concentration doped layer 277 may include SiAsP, and the sum of an As dopant concentration and a P dopant concentration in the high-concentration doped layer 277 may be about 1.5×10²¹ atom/cm³ to about 1×10²² atom/cm³.

In some embodiments, a second silicide film 271 may be between the backside contact BC and the high-concentration doped layer 277 and may be in contact with the high-concentration doped layer 277.

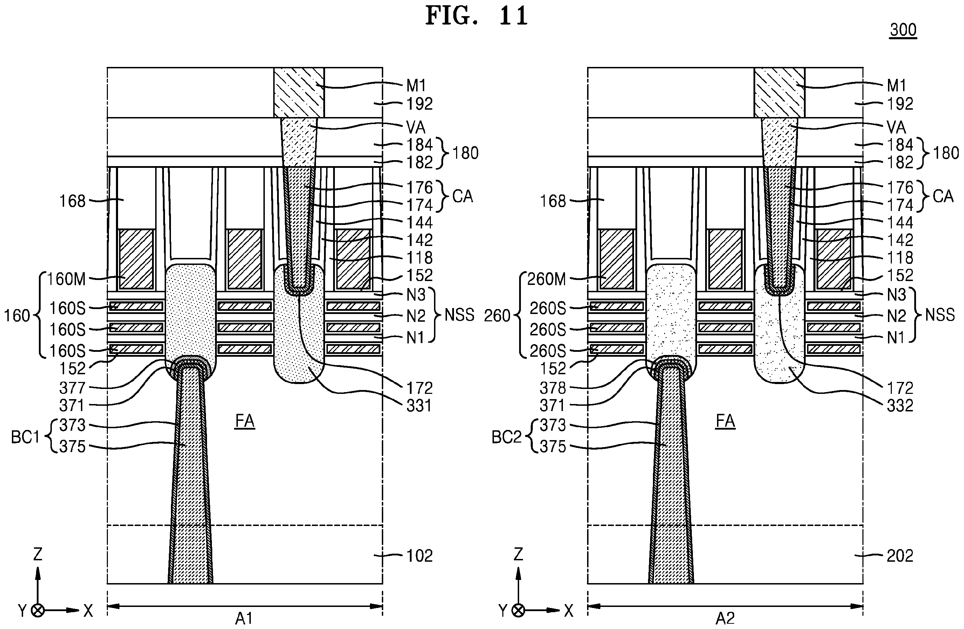

FIGS. 11 to 13 are cross-sectional views illustrating integrated circuit devices 300, 301, and 302 according to some embodiments.

Referring to FIG. 11, the integrated circuit device 300 may include a first region A1, in which a first source/drain region 331 is arranged, and a second region A2, in which a second source/drain region 332 is arranged. In some embodiments, the first source/drain region 331 may correspond to a P-channel metal-oxide semiconductor (PMOS) source/drain region. The second source/drain region 332 may correspond to an N-channel MOS (NMOS) source/drain region. In embodiments, for descriptions of the elements of the first region A1, the descriptions of the elements of the integrated circuit device 100 of FIGS. 2 to 4 may be referred to. In embodiments, for descriptions of the elements of the second region A2, the descriptions of the elements of the integrated circuit device 200 of FIGS. 9 and 10 may be referred to.

In the first region A1, a first high-concentration doped layer 377 may be disposed in a space between the first source/drain region 331 and a first backside contact BC1. The first high-concentration doped layer 377 may have a greater p-type dopant concentration than the first source/drain region 331. A second silicide film 371 may be disposed in a space between the first high-concentration doped layer 377 and the first backside contact BC1 and may be in contact with the first high-concentration doped layer 377.

The first source/drain region 331 may include or may be formed of an Si₁₋ₓGeₓ layer doped with a p-type dopant, where x is a positive fractional number greater than 0. The first high-concentration doped layer 377 may have a greater p-type dopant concentration than first source/drain region 331. For descriptions of the first source/drain region 331 and the first high-concentration doped layer 377, the descriptions of the source/drain region 130 and the high-concentration doped layer 177 of the integrated circuit device 100 of FIGS. 2 to 4 may be referred to.

In the second region A2, a second high-concentration doped layer 378 may be disposed in a space between the second source/drain region 332 and a second backside contact BC2. The second high-concentration doped layer 378 may have a greater n-type dopant concentration than the second source/drain region 332. The second silicide film 371 may be disposed in a space between the second high-concentration doped layer 378 and the second backside contact BC2 and may be in contact with the second high-concentration doped layer 378.

The second source/drain region 332 may include or may be formed of an Si layer doped with an n-type dopant. The second high-concentration doped layer 378 may have a greater n-type dopant concentration than second source/drain region 332. For descriptions of the second source/drain region 332 and the second high-concentration doped layer 378, the descriptions of the source/drain region 230 and the high-concentration doped layer 277 of the integrated circuit device 200 of FIGS. 9 and 10 may be referred to.

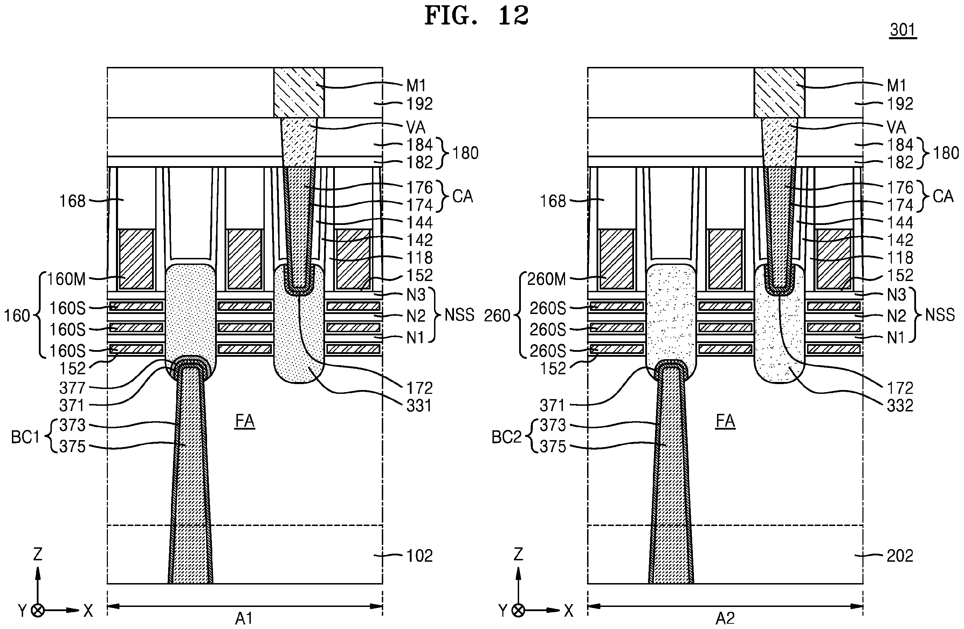

Referring to FIG. 12, the integrated circuit device 301 may include the first region A1, in which the first source/drain region 331 is arranged, and the second region A2, in which the second source/drain region 332 is arranged.

In the first region A1, the first high-concentration doped layer 377 may be disposed in a space between the first source/drain region 331 and the first backside contact BC1. The first high-concentration doped layer 377 may have a greater p-type dopant concentration than the first source/drain region 331. The second silicide film 371 may be disposed in a space between the first high-concentration doped layer 377 and the first backside contact BC1 and may be in contact with the first high-concentration doped layer 377.

Unlike the integrated circuit device 300, there may be no second high-concentration doped layer 378 between the second source/drain region 332 and the second backside contact BC2 in the second region A2. The second silicide film 371 may be disposed in a space between the second source/drain region 332 and the second backside contact BC2 and may be in contact with the second source/drain region 332.

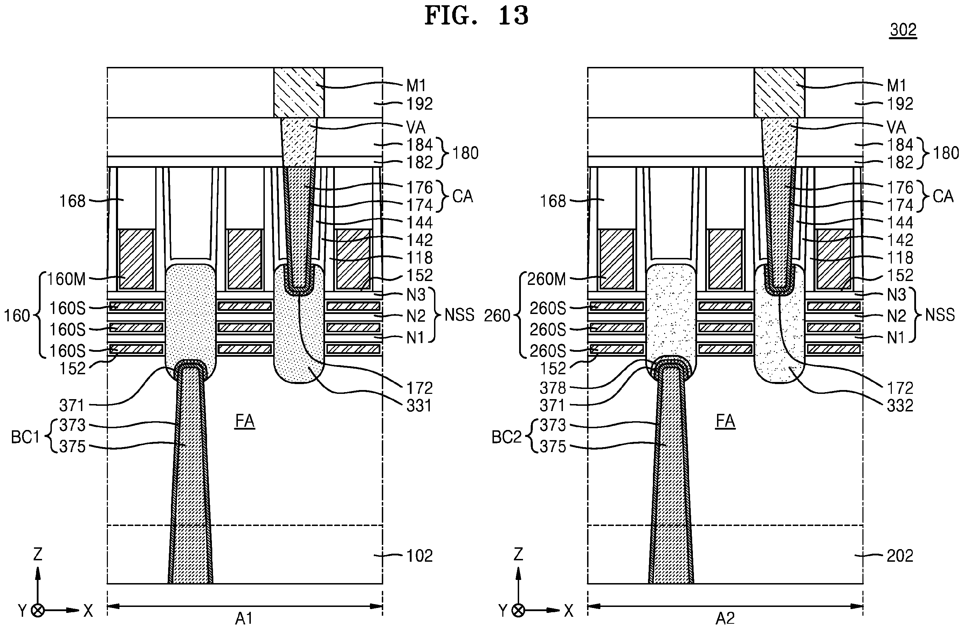

Referring to FIG. 13, the integrated circuit device 302 may include the first region A1, in which the first source/drain region 331 is arranged, and the second region A2, in which the second source/drain region 332 is arranged.

Unlike the integrated circuit device 300, there may be no first high-concentration doped layer 377 between the first source/drain region 331 and the first backside contact BC1 in the first region A1 of the integrated circuit device 302. The second silicide film 371 may be disposed in a space between the first source/drain region 331 and the first backside contact BC1 and may be in contact with the first source/drain region 331.

In the second region A2 of the integrated circuit device 302, the second high-concentration doped layer 378 may be disposed in a space between the second source/drain region 332 and the second backside contact BC2. The second high-concentration doped layer 378 may have a greater n-type dopant concentration than the second source/drain region 332. The second silicide film 371 may be disposed in a space between the second high-concentration doped layer 378 and the second backside contact BC2 and may be in contact with the second high-concentration doped layer 378.

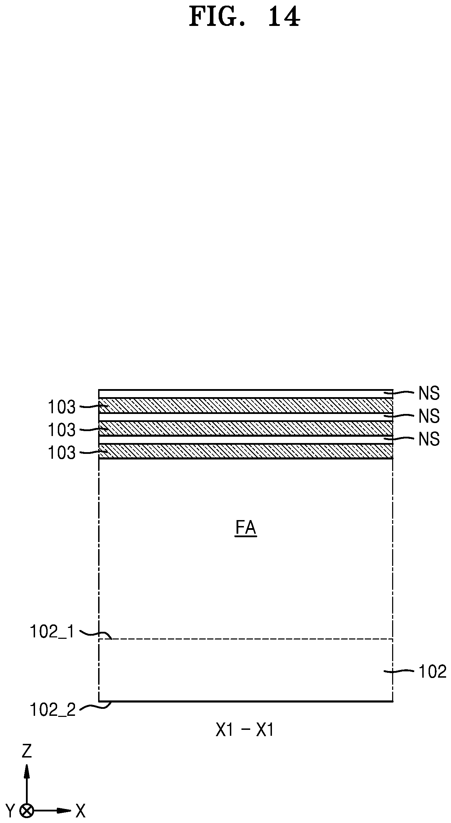

FIGS. 14 to 28 are cross-sectional views of the integrated circuit device 100 illustrating process steps of a method of manufacturing the integrated circuit device 100 according to some embodiments.

Referring to FIG. 14, a plurality of sacrificial semiconductor layers 103 and a plurality of nanosheet semiconductor layers NS may be alternately stacked on the substrate 102. The sacrificial semiconductor layers 103 may include or may be formed of a semiconductor material having etch selectivity with respect to a semiconductor material of the nanosheet semiconductor layers NS.

Thereafter, a plurality of fin-type active regions FA, which extend in the first horizontal direction (the X direction), may be formed by partially etching each of the sacrificial semiconductor layers 103, the nanosheet semiconductor layers NS, and the substrate 102. As a result, the first surface 102_1 of the substrate 102 may be formed and the fin-type active regions FA may be arranged on the first surface 102_1 of the substrate 102. In an embodiment, the fin-type active regions FA may be formed using an epitaxial growth process in which the fin-type active regions FA may be epitaxially grown from the first surface 102_1 of the substrate 101. A stack structure of the sacrificial semiconductor layers 103 and the nanosheet semiconductor layers NS may remain on the fin top FT (i.e., a top surface) of each of the fin-type active regions FA.

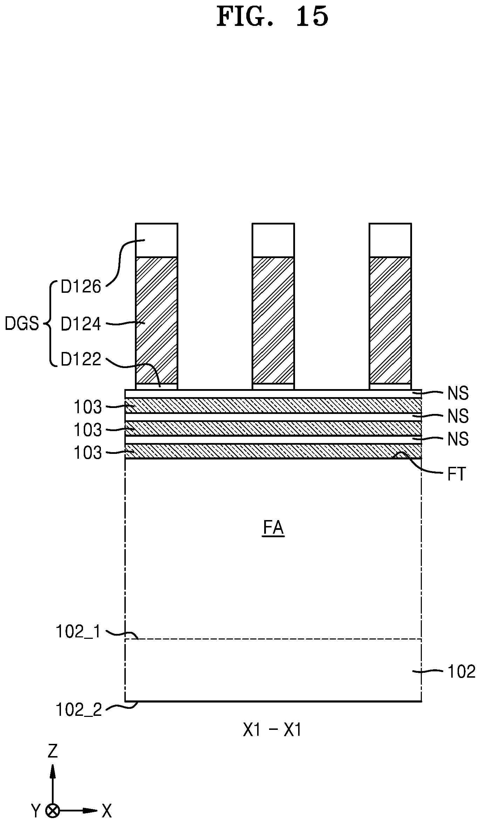

Referring to FIG. 15, a plurality of dummy gate structures DGS may be formed on the stack structure of the sacrificial semiconductor layers 103 and the nanosheet semiconductor layers NS.

The dummy gate structures DGS may extend lengthwise in the second horizontal direction (the Y direction). The dummy gate structures DGS may be spaced apart from each other in the first horizontal direction (the X direction). Each of the dummy gate structures DGS may include an oxide film D122, a dummy gate layer D124, and a capping layer D126 that are sequentially stacked. In some embodiments, the dummy gate layer D124 may include or may be formed of polysilicon and the capping layer D126 may include or may be a silicon nitride film.

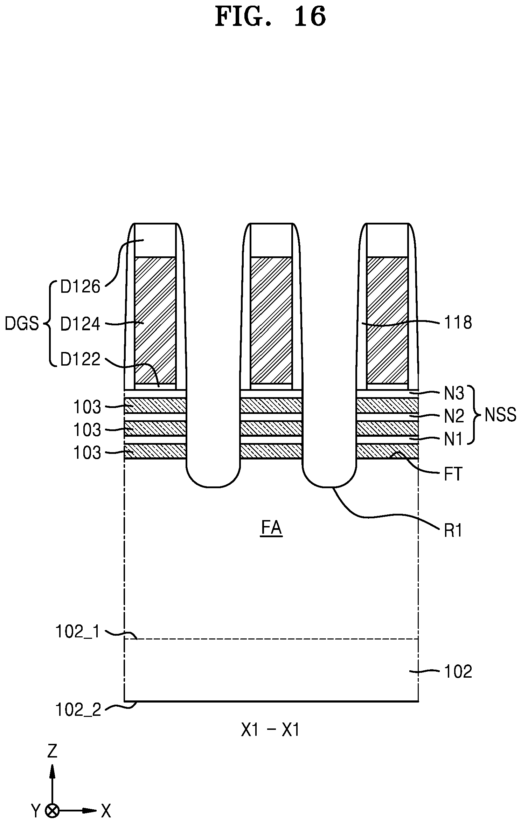

Referring to FIG. 16, outer insulating spacers 118 respectively covering opposite sidewalls of each of the dummy gate structures DGS may be formed. Thereafter, some of the sacrificial semiconductor layers 103 and some of the nanosheet semiconductor layers NS may be partially etched by using the dummy gate structure DGS and the outer insulating spacers 118 as etch masks. Accordingly, the nanosheet semiconductor layers NS may be divided into a plurality of nanosheet stacks NSS each including the first nanosheet N1, the second nanosheet N2, and the third nanosheet N3. The nanosheet stacks NSS may extend lengthwise in the second horizontal direction, and may be spaced apart from each other in the first horizontal direction.

A plurality of first recesses R1 may be formed by the etching process as described above. To form the first recesses R1, dry etching, wet etching, or a combination thereof may be used.

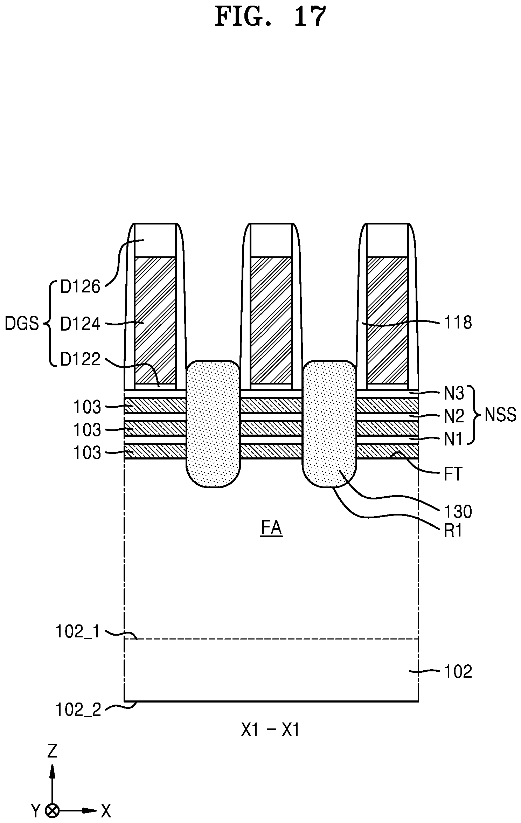

Referring to FIG. 17, a plurality of source/drain regions 130 may be respectively formed in the first recesses R1. In some embodiments, the source/drain regions 130 may be formed by epitaxially growing a semiconductor material from a surface of a fin-type active region FA exposed at the bottoms of the first recesses R1, the sidewalls of the first nanosheet N1, the second nanosheet N2, and the third nanosheet N3, which are included in each of the nanosheet stacks NSS, and the sidewalls of the sacrificial semiconductor layers 103.

In embodiments, to form the source/drain regions 130, the first semiconductor layer 130_1 (in FIG. 4) and the second semiconductor layer 130_2 (in FIG. 4) may be sequentially formed.

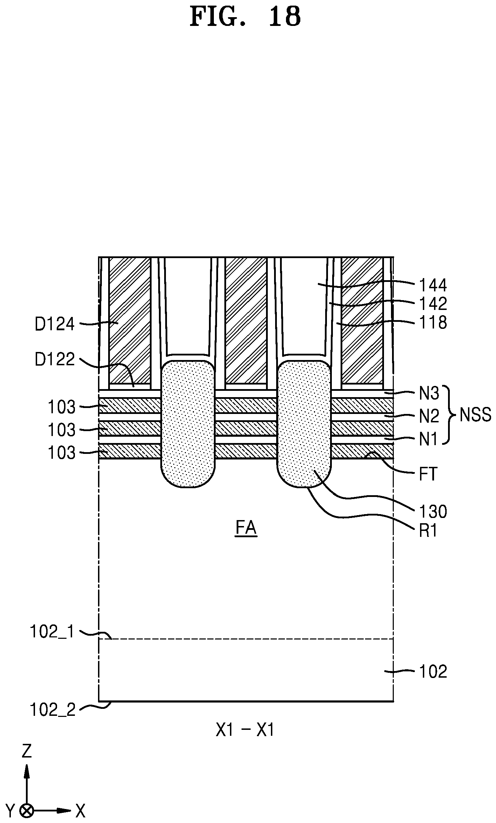

Referring to FIG. 18, an insulating liner 142 may be formed to cover the resultant structure of FIG. 17, which includes the source/drain regions 130, and an intergate insulating film 144 may be formed on the insulating liner 142. Thereafter, the top surface of the capping layer D126 may be exposed by planarizing the insulating liner 142 and the intergate insulating film 144.

Thereafter, the top surface of the dummy gate layer D124 may be exposed by removing the capping layer D126. The insulating liner 142 and the intergate insulating film 144 may be partially removed such that the top surface of the intergate insulating film 144 may be substantially coplanar with the top surface of the dummy gate layer D124.

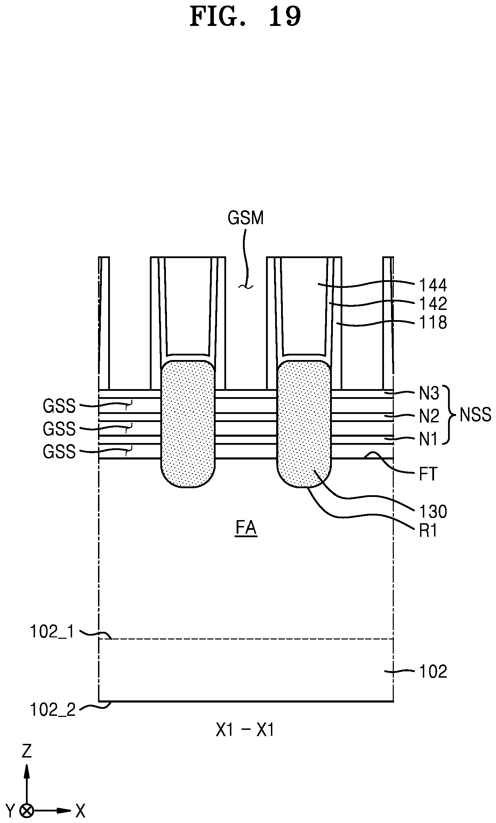

Referring to FIG. 19, a main gate space GSM may be formed by removing the dummy gate layer D124 and the oxide film D122 below the dummy gate layer D124 such that each of the nanosheet stacks NSS may be exposed by the main gate space GSM.

Subsequently, a sub gate space GSS may be formed among the first nanosheet N1, the second nanosheet N2, and the third nanosheet N3, and the fin top FT of the fin-type active region FA by removing the sacrificial semiconductor layers 103, which remain on the fin-type active region FA, through the main gate space GSM.

In some embodiments, the sacrificial semiconductor layers 103 having etch selectivity with respect to the first nanosheet N1, the second nanosheet N2, and the third nanosheet N3 may be selectively removed.

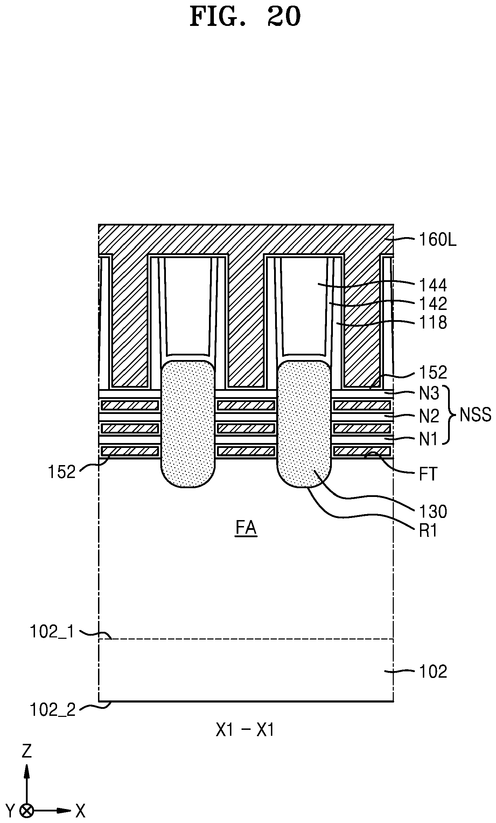

Referring to FIG. 20, a gate dielectric film 152 may be formed in the main gate space GSM and the sub gate space GSS. The gate dielectric film 152 may be formed to cover the exposed surface of the third nanosheet N3 in the main gate space GSM. The gate dielectric film 152 may be formed to cover the first nanosheet N1, the second nanosheet N2, and the third nanosheet N3 in the sub gate space GSS. The gate dielectric film 152 may be formed using atomic layer deposition (ALD).

Subsequently, a gate forming conductive layer 160L may be formed on the gate dielectric film 152 to fill the main gate space GSM and the sub gate space GSS and cover the top surface of the intergate insulating film 144. The gate forming conductive layer 160L may include or may be formed of metal, metal nitride, metal carbide, or a combination thereof. The gate forming conductive layer 160L may be formed using ALD or chemical vapor deposition (CVD).

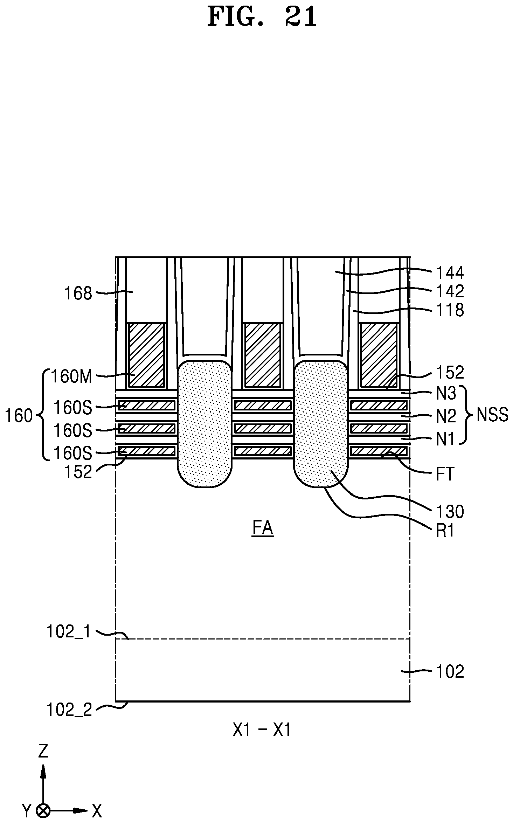

Referring to FIG. 21, an upper portion of the gate forming conductive layer 160L may be removed to expose the top surface of the intergate insulating film 144 and empty an upper portion of the main gate space GSM (see FIG. 19). As a result, a plurality of gate lines 160 may be formed from the gate forming conductive layer 160L.

During a time when the upper portion of the gate forming conductive layer 160L which fills an upper portion of the main gate space GSM is removed, an upper portion of each of the gate dielectric film 152 and the outer insulating spacers 118 may be consumed in the main gate space GSM, and the height of each of the gate dielectric film 152 and the outer insulating spacers 118 may decrease. Thereafter, a capping insulating pattern 168 may be formed on each of the gate lines 160 to fill the main gate space GSM.

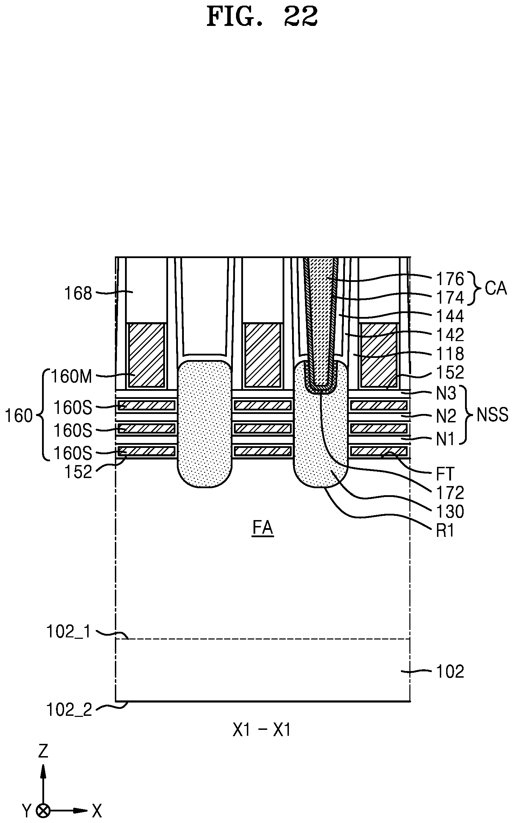

Referring to FIG. 22, a source/drain contact hole passing through an insulating structure including the insulating liner 142 and the intergate insulating film 144 may be formed to expose one of the source/drain regions 130. Thereafter, the source/drain contact hole may be made to extend further toward the substrate 102 by anisotropically etching the source/drain region 130 through the source/drain contact hole. Thereafter, a first metal silicide film 172 may be formed on the exposed surface of the source/drain region 130 at the bottom of the source/drain contact hole. In some embodiments, the forming of the first metal silicide film 172 may include forming a metal liner (not shown) to conformally cover the exposed surface of the source/drain region 130 and inducing a reaction between the source/drain region 130 and metal included in the metal liner by performing a heat treatment on the metal liner. After the first metal silicide film 172 is formed, the residue of the metal liner may be removed. During the process of forming the first metal silicide film 172, the source/drain region 130 may be partially consumed. In some embodiments, when the first metal silicide film 172 includes or is a titanium silicide film, the metal liner may include or is a Ti film.

Thereafter, a source/drain contact CA including a conductive barrier pattern 174 and a contact plug 176 may be formed on the first metal silicide film 172.

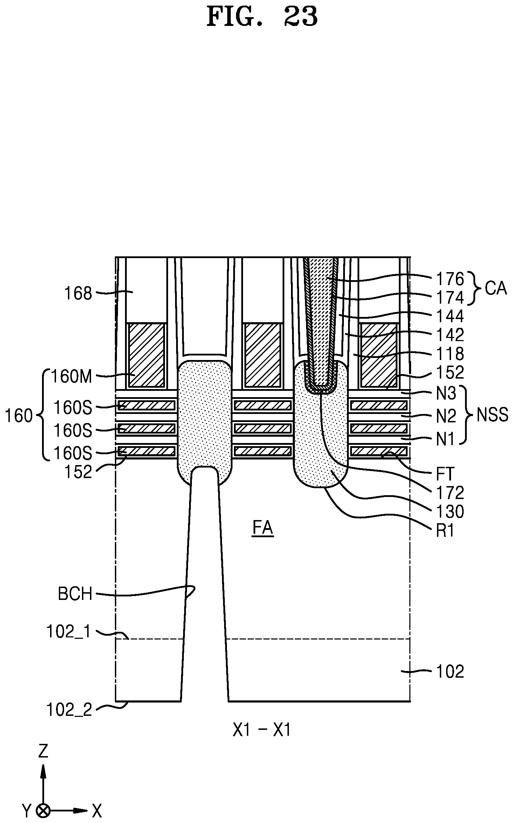

Referring to FIG. 23, a backside contact hole BCH may be formed through the substrate 102 and the fin-type active region FA to be connected to a source/drain region 130. In some embodiments, the process of forming the backside contact hole BCH may include forming a place holder (not shown) below the source/drain regions 130 and using the place holder as a marker.

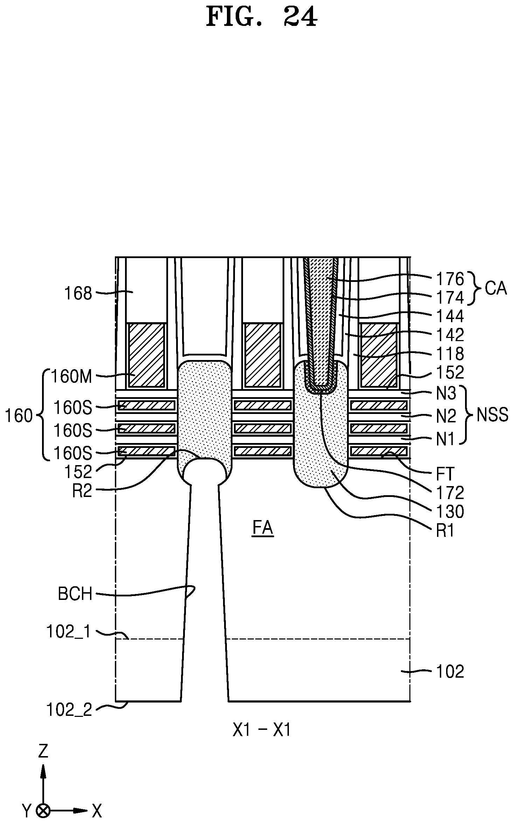

Referring to FIG. 24, a second recess R2 may be formed by further removing a portion of the source/drain regions 130 through the backside contact hole BCH. In some embodiments, the second recess R2 may be connected to the backside contact hole BCH.

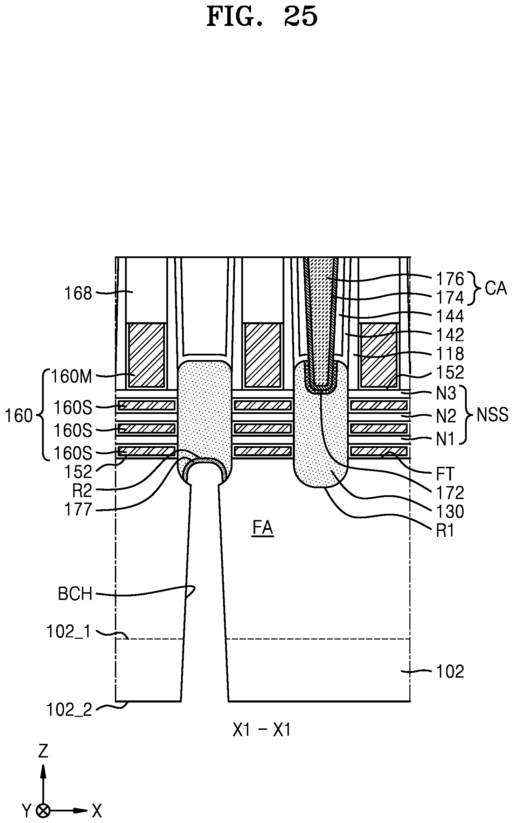

Referring to FIG. 25, a high-concentration doped layer 177 may be formed at the source/drain regions 130 exposed by the second recess R2. In embodiments, the high-concentration doped layer 177 may have a greater p-type dopant concentration than the source/drain regions 130. In some embodiments, a p-type dopant may be supplied to the source/drain regions 130 via the second recess R2 and the backside contact hole BCH, and the source/drain regions 130 exposed by the second recess R2 may be doped with the p-type dopant. The doped region of the source/drain regions 130 may be the high-concentration doped layer 177.

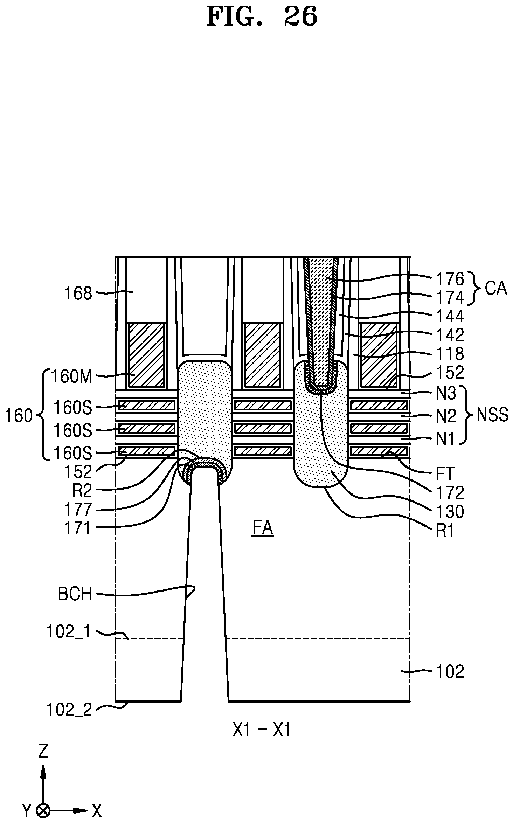

Referring to FIG. 26, a second metal silicide film 171 maybe formed on the high-concentration doped layer 177. The second metal silicide film 171 may be formed through a similar process to the first metal silicide film 172. In some embodiments, part of the high-concentration doped layer 177 of FIG. 25 may be converted to the second metal silicide film 171 by silicidation.

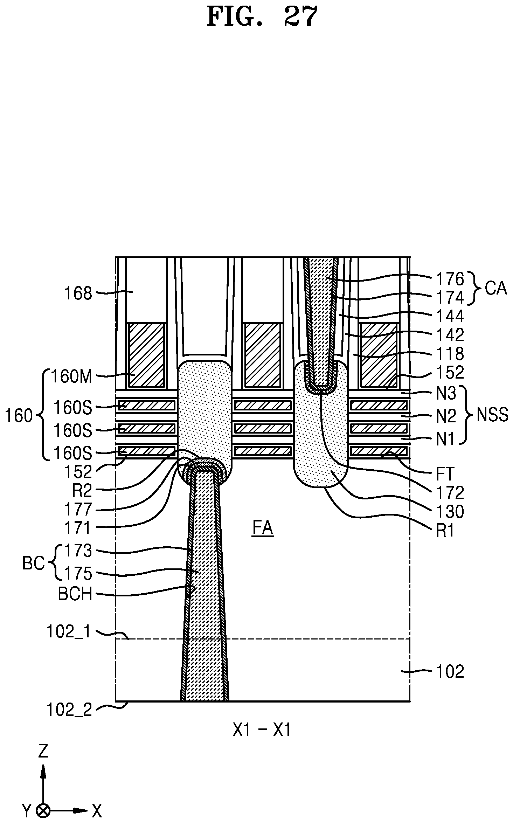

Referring to FIG. 27, a backside contact BC including a conductive barrier pattern 173 and a conductive plug 175 may be formed on the second metal silicide film 171.

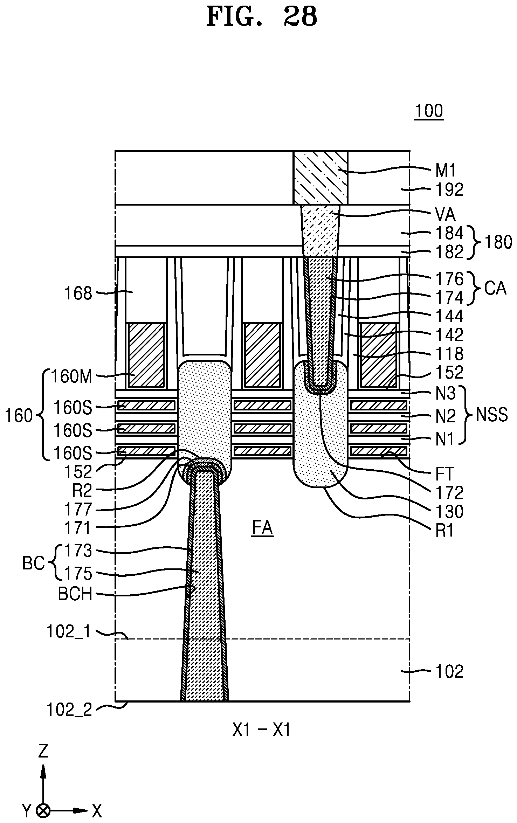

Referring to FIG. 28, an upper insulating structure 180 may be formed on the intergate insulating film 144 and the source/drain contact CA, and a via contact VA may be formed through the upper insulating structure 180 to be connected to the source/drain contact CA. Subsequently, an upper insulating film 192 may be formed on the upper insulating structure 180 and the via contact VA, and an interconnection line M1 penetrating through the upper insulating film 192 may be formed. Through the processes as described above, the integrated circuit device 100 of FIGS. 2 to 4 may be manufactured.

Although the method of manufacturing the integrated circuit device 100 as described with reference to FIGS. 2 to 4 has been described above with reference to FIGS. 14 to 28, those skilled in the art will be well aware that the integrated circuit devices 100A, 100B, 100C, 100_1, 100_2, 100_3, 200, 300, 301, and 302 as illustrated in FIGS. 5A to 13 and other integrated circuit devices having various structures changed and modified from the integrated circuit devices 100A, 100B, 100C, 100_1, 100_2, 100_3, 200, 300, 301, and 302 may be manufactured by making various changes and modifications in the descriptions of FIGS. 14 to 28 within the scope of the technical spirit of the present disclosure.

Embodiments are set out in the following clauses:
Clause 1. An integrated circuit device comprising:
   a substrate provided with a fin-type active region, wherein the fin-type active region is disposed at a first surface of the substrate and extends in a first horizontal direction that is parallel to the first surface of the substrate;
   a plurality of nanosheets disposed on a top surface of the fin-type active region and separated from the top surface of the fin-type active region;
   a gate line disposed on the fin-type active region, the gate line surrounding each of the plurality of nanosheets and extending in a second horizontal direction that crosses the first horizontal direction, wherein the second horizontal direction is parallel to the first surface of the substrate;
   a source/drain region disposed on the fin-type active region, a sidewall of the source/drain region being adjacent to the gate line and in contact with the plurality of nanosheets;
   a backside contact extending from a second surface of the substrate toward a lower portion of the source/drain region, wherein the second surface of the substrate is opposite to the first surface thereof; and
   a high-concentration doped layer disposed in the lower portion of the source/drain region,
   wherein the high-concentration doped layer has a dopant concentration greater than a dopant concentration of the source/drain region.
Clause 2. The integrated circuit device of clause 1, further comprising:
   a metal silicide film between the high-concentration doped layer and an upper portion of the backside contact.
Clause 3. The integrated circuit device of clause 2,
   wherein the metal silicide film is in contact with the high-concentration doped layer.
Clause 4. The integrated circuit device of clause 1,
   wherein the high-concentration doped layer has a convex shape into the source/drain region.
Clause 5. The integrated circuit device of clause 1,
   wherein the high-concentration doped layer conformally covers a top surface of an upper portion of the backside contact.
Clause 6. The integrated circuit device of clause 1,
   wherein the high-concentration doped layer has a stack structure including a first sub high-concentration doped layer and a second sub high-concentration doped layer.
Clause 7. The integrated circuit device of clause 6,
   wherein the first sub high-concentration doped layer and the second sub high-concentration doped layer differ in at least one of a dopant and a dopant concentration.
Clause 8. An integrated circuit device comprising:
   a fin-type active region disposed on a substrate and extending in a first horizontal direction, wherein the first horizontal direction is parallel to an upper surface of the substrate;
   a channel region disposed on the fin-type active region;
   a gate line disposed on the fin-type active region, the gate line surrounding the channel region and extending in a second horizontal direction that crosses the first horizontal direction, wherein the second horizontal direction is parallel to the upper surface of the substrate;
   a first source/drain region disposed on the fin-type active region, a sidewall of the source/drain region being adjacent to the gate line and in contact with the channel region;
   a first backside contact extending from a lower surface of the substrate toward a lower portion of the first source/drain region, wherein the lower surface of the substrate is opposite to the upper surface thereof; and
   a first high-concentration doped layer disposed in the lower portion of the first source/drain region,
   wherein the first high-concentration doped layer and the first source/drain region include a first dopant, and
   wherein a concentration of the first dopant in the first high-concentration doped layer is greater than a concentration of the first dopant in the first source/drain region.
Clause 9. The integrated circuit device of clause 8,
   wherein the first source/drain region includes:
      a first semiconductor layer contacting the channel region and the fin-type active region; and
      a second semiconductor layer on the first semiconductor layer,
   wherein the first semiconductor layer is disposed in a space between the second semiconductor layer and the channel region,
   wherein each of the first semiconductor layer, the second semiconductor layer, and the first high-concentration doped layer includes an Si₁₋ₓGeₓ layer doped with the first dopant, where x is a positive fractional number, and
   wherein the first dopant is a p-type dopant.
Clause 10. The integrated circuit device of clause 9,
   wherein a p-type dopant concentration of the p-type dopant in the second semiconductor layer is greater than a p-type dopant concentration of the p-type dopant in the first semiconductor layer, and
   wherein a p-type dopant concentration of the p-type dopant in the first high-concentration doped layer is greater than a p-type dopant concentration of the p-type dopant in the second semiconductor layer.
Clause 11. The integrated circuit device of clause 10,
   wherein the p-type dopant concentration of the p-type dopant in the first high-concentration doped layer is a value selected from a range of about 5×10²⁰ atom/cm³ to about 10²² atom/cm³.
Clause 12. The integrated circuit device of clause 8,
   wherein the first source/drain region includes:
      a first semiconductor layer contacting the channel region and the fin-type active region, and
      a second semiconductor layer on the first semiconductor layer,
   wherein the first semiconductor layer is disposed in a space between the second semiconductor layer and the channel region,
   wherein each of the first semiconductor layer, the second semiconductor layer, and the first high-concentration doped layer includes an Si layer doped with the first dopant, and
   wherein the first dopant is an n-type dopant.
Clause 13. The integrated circuit device of clause 12,
   wherein an n-type dopant concentration of the n-type dopant in the second semiconductor layer is greater than an n-type dopant concentration of the n-type dopant in the first semiconductor layer, and
   wherein an n-type dopant concentration of the n-type dopant in the first high-concentration doped layer is greater than an n-type dopant concentration of the n-type dopant in the second semiconductor layer.
Clause 14. The integrated circuit device of clause 13,
   wherein the n-type dopant concentration of the n-type dopant in the first high-concentration doped layer is a value selected from a range of about 1.5×10²¹ atom/cm³ to about 10²² atom/cm³.
Clause 15. An integrated circuit device comprising:
   a fin-type active region disposed on a substrate and extending in a first horizontal direction, wherein the first horizontal direction is parallel to an upper surface of the substrate;
   a plurality of nanosheets disposed on a top surface of the fin-type active region, separated from the top surface of the fin-type active region, and having different distances from the top surface of the fin-type active region in a vertical direction that is perpendicular to the upper surface of the substrate;
   a gate line disposed on the fin-type active region, the gate line surrounding each of the plurality of nanosheets and extending lengthwise in a second horizontal direction that crosses the first horizontal direction, wherein the second horizontal direction is parallel to the upper surface of the substrate;
   a source/drain region adjacent to the plurality of nanosheets in the first horizontal direction;
   a backside contact extending from a lower surface of the substrate toward a lower portion of the source/drain region, wherein the lower surface of the substrate is opposite to the upper surface thereof;
   a high-concentration doped layer disposed in the lower portion of the source/drain region; and
   a metal silicide film between the high-concentration doped layer and an upper portion of the backside contact,
   wherein the source/drain region includes:
      a first semiconductor layer contacting the fin-type active region, and
      a second semiconductor layer on the first semiconductor layer,
      wherein the metal silicide film is in contact with the high-concentration doped layer,
      wherein the high-concentration doped layer, the first semiconductor layer, and the second semiconductor layer include a first dopant,
      wherein a first concentration of the first dopant in the first semiconductor layer is less than a second concentration of the first dopant in the second semiconductor layer, and
      wherein a third concentration of the first dopant in the high-concentration doped layer is greater than the second concentration of the first dopant in the second semiconductor layer.

For clarity, we note regarding specific terms as used throughout this specification that:
- "disposed at" generally means indirectly or directly in contact with, eg in embodiments a high-concentration doped layer may be immediately adjacent the source/drain region such that it functions as a portion of the source/drain region;
- "on" in relation to embodiments of the integrated device is generally interchangeable with "over" or "above", neither of which latter terms however imply any particular orientation of an embodiment. For example, "on", "over" or "above" do not necessarily imply any direct contact to a feature and may merely mean a position on an opposite side of the feature relative to the substrate;
- "upper" and "lower" are relative and generally relate to proximity to a surface of the substrate of a device embodiment, eg relative to such a surface that supports other physical features of an embodiment such as a fin-type active region: generally, "upper" and "lower" therefore respectively mean 'further from' and `nearer to' a substrate. Thus, terms such as `upper' or 'lower' do not necessarily imply any particular orientation of the device;
- "horizontal" and "vertical" are relative and thus similarly do not necessarily imply and such particular orientation. For example, "horizontal" generally means substantially or exactly parallel to a surface of the substrate of a device embodiment, eg parallel to such a surface that supports other physical features of an embodiment such as a fin-type active region. Similarly, "vertical" generally means substantially or exactly perpendicular to such a surface;
- "fin-type" generally means "protruding from a surface", eg in relation to a fin-type active region that protrudes from substrate surface in embodiments;
- "nanosheet" generally means a layer having a thickness in a range from about (eg exactly) 1 nm to about 100 nm, more preferably from about 1nm to about 10nm, eg within a range from about 4 nm to about 6 nm. In embodiments, a nanosheet may comprise one or more nanowire(s) each having such a thickness as eg a diameter, width and/or depth of the nanowire;
- "crosses" in relation to directions generally means directions that are not parallel, eg are substantially or exactly perpendicular to each other. Such directions may in embodiments lie in eg parallel planes, for example if both directions are horizontal relative to a horizontal substrate surface;
- "source/drain region" generally means a region that comprises a source region and/or drain region;
- "toward" may mean "to", eg extending to be directly or indirectly in contact with; for example a backside contact extending toward a portion of a source/drain region may be directly adjacent to the portion or separated from the portion by intermediate layer(s).

Generally, any embodiment disclosed herein may advantageously provide an integrated circuit device having increased performance and/or reliability.

While the present disclosure has been particularly shown and described with reference to some embodiments thereof, it will be understood that various changes in form and details may be made therein without departing from the scope of the following claims.

## Claims

1. An integrated circuit device comprising:
a substrate;
a fin-type active region disposed on the substrate and extending in a first direction, wherein the first direction is parallel to an upper surface of the substrate;
a channel region disposed above the fin-type active region;
a gate line disposed above the fin-type active region, the gate line surrounding the channel region and extending in a second direction that crosses the first direction, wherein the second direction is parallel to the upper surface of the substrate;
a source/drain region disposed above the fin-type active region, a sidewall of the source/drain region being adjacent to the gate line and in contact with the channel region;
a high-concentration doped layer disposed at a portion of the source/drain region;
a backside contact extending from a lower surface of the substrate toward the high-concentration doped layer, wherein the lower surface of the substrate is opposite to the upper surface thereof; and
wherein the high-concentration doped layer and the source/drain region include a dopant, and
wherein a concentration of the dopant in the high-concentration doped layer is greater than a concentration of the dopant in the source/drain region.

2. The integrated circuit device of claim 1,
wherein the source/drain region includes:
a first semiconductor layer contacting the channel region and the fin-type active region; and
a second semiconductor layer above the first semiconductor layer,
wherein the first semiconductor layer is disposed in a space between the second semiconductor layer and the channel region,
wherein each of the first semiconductor layer, the second semiconductor layer, and the high-concentration doped layer includes an Si₁₋ₓGeₓ layer doped with the dopant, where x is a positive fractional number, and
wherein the dopant is a p-type dopant.

3. The integrated circuit device of claim 2,
wherein a p-type dopant concentration of the p-type dopant in the second semiconductor layer is greater than a p-type dopant concentration of the p-type dopant in the first semiconductor layer, and
wherein a p-type dopant concentration of the p-type dopant in the high-concentration doped layer is greater than a p-type dopant concentration of the p-type dopant in the second semiconductor layer.

4. The integrated circuit device of claim 2 or 3,
wherein the p-type dopant concentration of the p-type dopant in the high-concentration doped layer is a value within a range of about 5×10²⁰ atom/cm³ to about 10²² atom/cm³.

5. The integrated circuit device of claim 1,
wherein the source/drain region includes:
a first semiconductor layer contacting the channel region and the fin-type active region, and
a second semiconductor layer above the first semiconductor layer,
wherein the first semiconductor layer is disposed in a space between the second semiconductor layer and the channel region,
wherein each of the first semiconductor layer, the second semiconductor layer, and the high-concentration doped layer includes an Si layer doped with the dopant, and
wherein the dopant is an n-type dopant.

6. The integrated circuit device of claim 5,
wherein an n-type dopant concentration of the n-type dopant in the second semiconductor layer is greater than an n-type dopant concentration of the n-type dopant in the first semiconductor layer, and
wherein an n-type dopant concentration of the n-type dopant in the high-concentration doped layer is greater than an n-type dopant concentration of the n-type dopant in the second semiconductor layer.

7. The integrated circuit device of claim 5 or 6,
wherein the n-type dopant concentration of the n-type dopant in the high-concentration doped layer is a value within a range of about 1.5×10²¹ atom/cm³ to about 10²² atom/cm³.

8. The integrated circuit device of any preceding claim, comprising:
the substrate provided with the fin-type active region, wherein the fin-type active region is disposed at a first surface of the substrate and extends in the first direction that is parallel to the first surface of the substrate;
the channel region comprising a plurality of nanosheets disposed above and separated from a surface of the fin-type active region;
the gate line disposed above the fin-type active region, the gate line surrounding each of the plurality of nanosheets and extending in the second direction that crosses the first direction, wherein the second direction is parallel to the first surface of the substrate;
the source/drain region disposed above the fin-type active region, the sidewall of the source/drain region being adjacent to the gate line and in contact with the plurality of nanosheets;
a high-concentration doped layer disposed at a portion of the source/drain region;
the backside contact extending from a second surface of the substrate toward the high-concentration doped layer, wherein the second surface of the substrate is opposite to the first surface thereof,
wherein the high-concentration doped layer has the dopant concentration greater than the dopant concentration of the source/drain region.

9. The integrated circuit device of claim 8, further comprising:
a metal silicide film between the high-concentration doped layer and a portion of the backside contact.

10. The integrated circuit device of claim 9,
wherein the metal silicide film is in contact with the high-concentration doped layer.

11. The integrated circuit device of any one of claims 8 - 10,
wherein the high-concentration doped layer has a convex shape into the source/drain region.

12. The integrated circuit device of any one of claims 8 to 11,
wherein the high-concentration doped layer conformally covers a surface of a portion of the backside contact.

13. The integrated circuit device of any one of claims 8 to 12,
wherein the high-concentration doped layer has a stack structure including a first sub high-concentration doped layer and a second sub high-concentration doped layer.

14. The integrated circuit device of claim 13,
wherein the first sub high-concentration doped layer and the second sub high-concentration doped layer differ in at least one of a dopant and a dopant concentration.

15. An integrated circuit device according to any preceding claim, comprising:
the fin-type active region disposed n the substrate and extending in a first direction, wherein the first direction is parallel to an upper surface of the substrate;
the channel region comprising a plurality of nanosheets that are disposed above, separated from and have different distances from a surface of the fin-type active region, the different distances being in a direction that is perpendicular to the upper surface of the substrate;
the gate line disposed above the fin-type active region, the gate line surrounding each of the plurality of nanosheets and extending lengthwise in a second direction that crosses the first direction, wherein the second direction is parallel to the upper surface of the substrate;
the source/drain region adjacent to the plurality of nanosheets in the first direction;
a high-concentration doped layer disposed at a portion of the source/drain region;
the backside contact extending from a lower surface of the substrate toward the high-concentration doped layer, wherein the lower surface of the substrate is opposite to the upper surface thereof; and
a metal silicide film between the high-concentration doped layer and a portion of the backside contact,
wherein the source/drain region includes:
a first semiconductor layer contacting the fin-type active region, and
a second semiconductor layer on the first semiconductor layer,
wherein the metal silicide film is in contact with the high-concentration doped layer,
wherein the high-concentration doped layer, the first semiconductor layer, and the second semiconductor layer include a dopant,
wherein a first concentration of the dopant in the first semiconductor layer is less than a second concentration of the dopant in the second semiconductor layer, and
wherein a third concentration of the dopant in the high-concentration doped layer is greater than the second concentration of the dopant in the second semiconductor layer.
